# EUROPEAN PATENT SPECIFICATION

(11) **EP 3 093 834 B1**
(45) Date of publication and mention of the grant of the patent: **12.05.2021**
(21) Application number: 15002641.7
(22) Date of filing: 09.09.2015
(51) Int. Cl.: G09F 9/33, H01L 25/075, H01L 33/00, H01L 33/38, H01L 33/40, H01L 33/46, H01L 33/62, H01L 33/32

(54) **DISPLAY DEVICE USING SEMICONDUCTOR LIGHT EMITTING DEVICE AND MANUFACTURING METHOD THEREOF**
ANZEIGEVORRICHTUNG MIT LICHTEMITTIERENDEM HALBLEITERBAUELEMENT UND IHR HERSTELLUNGSVERFAHREN
DISPOSITIF D'AFFICHAGE UTILISANT UN DISPOSITIF ÉLECTROLUMINESCENT À SEMI-CONDUCTEUR ET SON PROCÉDÉ DE FABRICATION

(30) Priority: 24.04.2015 KR 20150058283
(43) Date of publication of application: 16.11.2016
(73) Proprietor: LG Electronics Inc., Seoul 07336 (KR)
(72) Inventor: Lee, Eunah, 06772 Seoul (KR); Kang, Mingu, 06772 Seoul (KR)
(74) Representative: Katérle, Axel

(56) References cited:
- EP-A2- 2 546 894
- WO-A1-2008/060053
- WO-A1-2014/163325
- US-A1- 2007 114 552
- US-A1- 2015 054 008

## Description

### BACKGROUND OF THE INVENTION

### 1. Field of the Invention

The present disclosure relates to a display device and a manufacturing method thereof, and more particularly, to a flexible display device using a semiconductor light emitting device.

### 2. Background of the Invention

In recent years, display devices having excellent characteristics such as low profile, flexibility and the like have been developed in the display technical field. Currently commercialized main displays are represented by liquid crystal displays (LCDs) and active matrix organic light emitting diodes (AMOLEDs). However, there exist problems such as mediocre response time, difficult implementation of flexibility in the instance of LCDs, and there exist drawbacks such as a short life span, mediocre yield as well as low flexibility in the instance of AMOLEDs.

Further, light emitting diodes (LEDs) are well known light emitting devices for converting an electrical current to light, and have been used as a light source for displaying an image in an electronic device including information communication devices since red LEDs using GaAsP compound semiconductors were made commercially available in 1962, together with a GaP:N-based green LEDs. Accordingly, the semiconductor light emitting devices may be used to implement a flexible display, thereby presenting a scheme for solving the problems.

A flexible display using the semiconductor light emitting device may be required to enhance luminous efficiency of semiconductor light emitting devices. Further, a solution to the necessity involves restrictions that manufacturing a semiconductor light emitting device should not be complicated.

EP 2 546 894 A2 discloses a semiconductor light emitting device including a stacked body, a first and a second electrode, and a reflecting layer covering a side surface of the stacked body.

US 2007/0114552 A1 discloses a vertical GaN-based LED including a light-emitting structure in which an n-type GaN layer, an active layer and a p-type GaN layer are sequentially formed under a n-electrode, wherein the structure further includes a passivation layer formed to cover the side and bottom surfaces of the light-emitting structure.

WO 2014/163325 A1 discloses a display device using a semiconductor light emitting device, the display device comprising a first substrate comprising an electrode portion, a conductive adhesive layer located on the first substrate, and a plurality of semiconductor light emitting devices at least part of which are buried in an upper region of the conductive adhesive layer to constitute individual pixels electrically connected to the electrode portion, wherein the conductive adhesive layer contains a non-transparent resin to block light between the semiconductor light emitting devices.

### SUMMARY OF THE INVENTION

Therefore, an aspect of the detailed description is to provide a structure for enhancing luminance of a display device, and a manufacturing method thereof.

Another aspect of the detailed description is to alleviate or prevent loss of light in the aspect of semiconductor light emitting devices.

To achieve these and other advantages and in accordance with the purpose of this specification, as embodied and broadly described herein, the present disclosure provides in one aspect a display device in accordance with claim 1. Prefered embodiments are defined in the dependent claims. The display device includes a plurality of semiconductor light emitting devices installed on a substrate, wherein at least one of the semiconductor light emitting devices includes: a first conductivity type electrode and a second conductivity type electrode; a first conductivity type semiconductor layer on which the first conductivity type electrode is disposed; a second conductivity type semiconductor layer overlapping the first conductivity type semiconductor layer and on which the second conductivity type electrode is disposed; and a passivation layer formed to cover side surfaces of the first conductivity type semiconductor layer and the second conductivity type semiconductor layer, wherein the passivation layer includes a plurality of layers having different refractive indices to reflect light emitted to the side surfaces.

A method for manufacturing a display device not forming part of the present invention includes: growing a first conductivity type semiconductor layer, an active layer, and a second conductivity type semiconductor layer on a substrate; isolating semiconductor light emitting devices on the substrate through etching; forming a passivation layer to cover side surfaces of the semiconductor light emitting devices; and connecting the semiconductor light emitting devices with the passivation layer formed thereon to a wiring substrate and removing the substrate, wherein the passivation layer include a plurality of layers having different refractive indices to reflect light emitted to the side surfaces.

Further scope of applicability of the present application will become more apparent from the detailed description given hereinafter. However, it should be understood that the detailed description and specific examples, while indicating preferred embodiments of the invention, are given by way of illustration only, the invention being defined by the appended claims.

### BRIEF DESCRIPTION OF THE DRAWINGS

The accompanying drawings, which are included to provide a further understanding of the invention and are incorporated in and constitute a part of this specification, illustrate exemplary embodiments and together with the description serve to explain the principles of the invention.

In the drawings:
FIG. 1 is a conceptual view illustrating a display device using a semiconductor light emitting device according to an embodiment useful for understanding the invention;
FIG. 2 is a partial enlarged view of portion "A" in FIG. 1, and FIGS. 3A and 3B are cross-sectional views taken along lines B-B and C-C in FIG. 2;
FIG. 4 is a conceptual view illustrating a flip-chip type semiconductor light emitting device in FIG. 3A;
FIGS. 5A through 5C are conceptual views illustrating various forms for implementing colors in connection with a flip-chip type semiconductor light emitting device;
FIG. 6 is cross-sectional views illustrating a method of manufacturing a display device using a semiconductor light emitting device;
FIG. 7 is a perspective view illustrating a display device using a semiconductor light emitting device according to an embodiment useful for understanding the invention;
FIG. 8 is a cross-sectional view taken along line D-D in FIG. 7;
FIG. 9 is a conceptual view illustrating a vertical type semiconductor light emitting device in FIG. 8;
FIG. 10 is an enlarged view of a portion 'A' of FIG. 1, illustrating a semiconductor light emitting device having a structure according to an embodiment of the present invention;
FIG. 11A is a cross-sectional view taken along line E-E of FIG. 10;
FIG. 11B is a cross-sectional view taken along line F-F of FIG. 10;
FIG. 12 is a conceptual view illustrating the semiconductor light emitting device having a novel structure of FIG. 11A;
FIG. 13A is a graph illustrating reflectivity according to materials of a passivation layer;
FIG. 13B is a graph illustrating reflectivity according to the number of repeated stacking of a plurality of layers;
FIGS. 14A, 14B, 14C, 14D, 15A, 15B, and 15C are cross-sectional views illustrating a method for manufacturing a display device using a semiconductor light emitting device;
FIG. 16 is an enlarged view of a portion 'A' of FIG. 1, illustrating another embodiment not part of the present invention;
FIG. 17A is a cross-sectional view taken along line G-G of FIG. 15;
FIG. 17B is a cross-sectional view taken along line H-H of FIG. 15; and
FIG. 18 is a conceptual view illustrating a flip chip type semiconductor light emitting device of FIG. 17A.

### DETAILED DESCRIPTION OF THE INVENTION

Hereinafter, the embodiments disclosed herein, some being illustrative and some being part of the invention, will be described in detail with reference to the accompanying drawings, and the same or similar elements are designated with the same numeral references regardless of the numerals in the drawings and their redundant description will be omitted. A suffix "module" or "unit" used for constituent elements disclosed in the following description is merely intended for ease of description of the specification, and the suffix itself does not give any special meaning or function. Also, it should be noted that the accompanying drawings are merely illustrated for ease of explaining the concept of the invention, and therefore, they should not be construed to limit the technological concept disclosed herein by the accompanying drawings. Furthermore, when an element such as a layer, region or substrate is referred to as being "on" another element, it can be directly on the other element or an intermediate element may also be interposed therebetween.

A display device disclosed herein may include a portable phone, a smart phone, a laptop computer, a digital broadcast terminal, a personal digital assistant (PDA), a portable multimedia player (PMP), a navigation, a slate PC, a tablet PC, an ultrabook, a digital TV, a desktop computer, and the like. However, it would be easily understood by those skilled in the art that a configuration disclosed herein may be applicable to any displayable device even though it is a new product type which will be developed later.

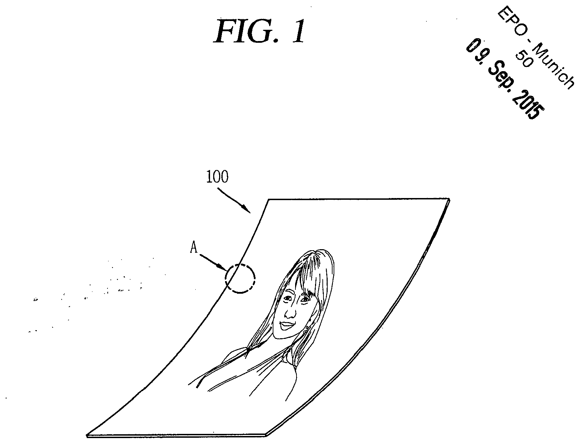

FIG. 1 is a conceptual view illustrating a display device 100 using a semiconductor light emitting device according to an embodiment useful for understanding the invention. According to the drawing, information processed in the controller of the display device 100 can be displayed using a flexible display. The flexible display 100 may include a flexible, bendable, twistable, foldable and rollable display. For example, the flexible display may be fabricated on a thin and flexible substrate that can be warped, bent, folded or rolled like a paper sheet while maintaining the display characteristics of a flat display in the related art.

A display area of the flexible display 100 becomes a plane in a configuration that the flexible display is not warped (for example, a configuration having an infinite radius of curvature, hereinafter, referred to as a "first configuration"). The display area thereof becomes a curved surface in a configuration that the flexible display is warped by an external force in the first configuration (for example, a configuration having a finite radius of curvature, hereinafter, referred to as a "second configuration"). As illustrated in the drawing, information displayed in the second configuration may be visual information displayed on a curved surface. The visual information can be implemented by individually controlling the light emission of sub-pixels disposed in a matrix form. The sub-pixel denotes a minimum unit for implementing one color.

The sub-pixel of the flexible display can be implemented by a semiconductor light emitting device. According to the embodiment of the invention, a light emitting diode (LED) is a type of semiconductor light emitting device. The light emitting diode can be formed with a small size to perform the role of a sub-pixel even in the second configuration through this.

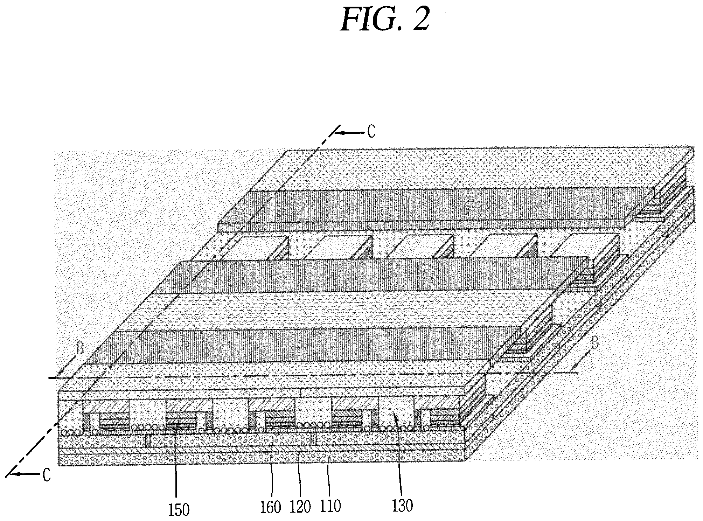

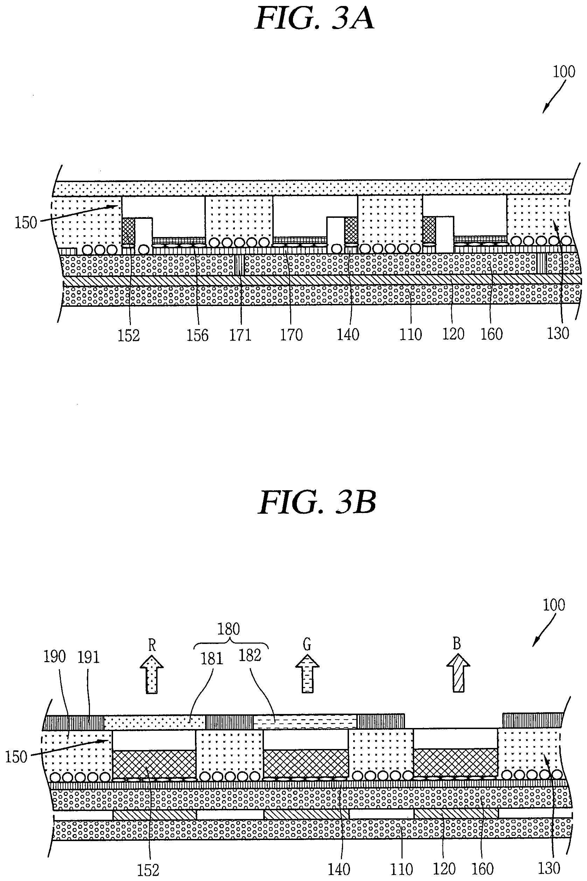

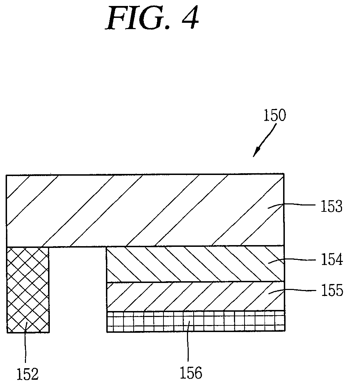

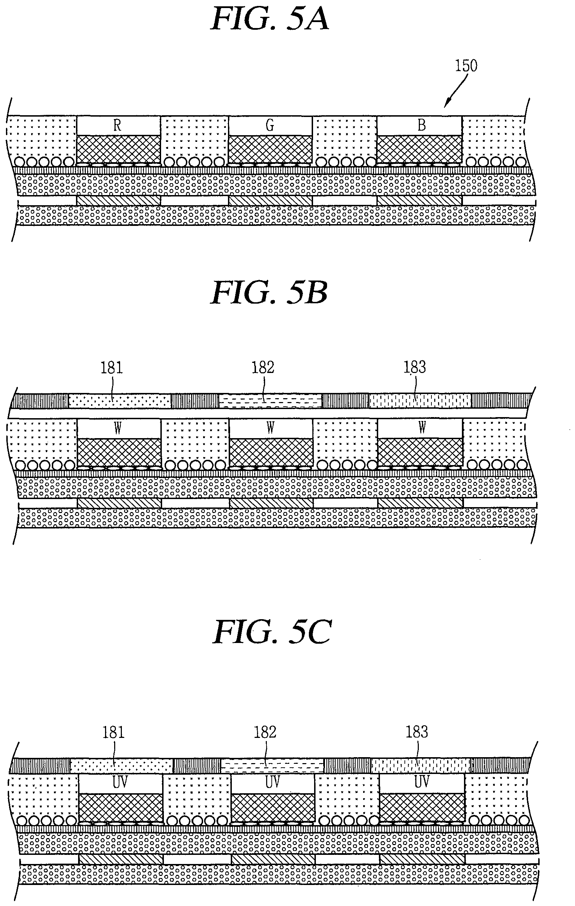

Hereinafter, a flexible display implemented using the light emitting diode will be described in more detail with reference to the accompanying drawings. In particular, FIG. 2 is a partial enlarged view of portion "A" in FIG. 1, FIGS. 3A and 3B are cross-sectional views taken along lines B-B and C-C in FIG. 2, FIG. 4 is a conceptual view illustrating a flip-chip type semiconductor light emitting device in FIG. 3A, and FIGS. 5A through 5C are conceptual views illustrating various forms for implementing colors in connection with a flip-chip type semiconductor light emitting device.

According to the drawings in FIGS. 2, 3A and 3B, a display device 100 using a passive matrix (PM) type semiconductor light emitting device is shown by way of example. However, the following illustration is also applicable to an active matrix (AM) type semiconductor light emitting device in other illustrative embodiments.

As shown, the display device 100 includes a substrate 110, a first electrode 120, a conductive adhesive layer 130, a second electrode 140, and a plurality of semiconductor light emitting devices 150. The substrate 110 may be a flexible substrate and include glass or polyimide (PI) to implement the flexible display device. In addition, as a flexible material, any one such as polyethylene naphthalate (PEN), polyethylene terephthalate (PET) or the like may be used. Furthermore, the substrate 110 may be either one of transparent and non-transparent materials.

The substrate 110 may be a wiring substrate disposed with the first electrode 120, and thus the first electrode 120 can be placed on the substrate 110. According to the drawing, an insulating layer 160 can be disposed on the substrate 110 placed with the first electrode 120, and an auxiliary electrode 170 can be placed on the insulating layer 160. In this instance, the insulating layer 160 deposited on the substrate 110 may be a single wiring substrate. More specifically, the insulating layer 160 may be incorporated into the substrate 110 with an insulating and flexible material such as polyimide (PI), PET, PEN or the like to form a single wiring substrate.

The auxiliary electrode 170 as an electrode for electrically connecting the first electrode 120 to the semiconductor light emitting device 150 is placed on the insulating layer 160, and disposed to correspond to the location of the first electrode 120. For example, the auxiliary electrode 170 has a dot shape, and can be electrically connected to the first electrode 120 by an electrode hole 171 passing through the insulating layer 160. The electrode hole 171 can be formed by filling a conductive material in a via hole.

Referring to the drawings, the conductive adhesive layer 130 can be formed on one surface of the insulating layer 160, but the embodiments are not limited to this. For example, it is possible to also have a structure in which a layer performing a specific function is formed between the insulating layer 160 and conductive adhesive layer 130, or the conductive adhesive layer 130 is disposed on the substrate 110 with no insulating layer 160. The conductive adhesive layer 130 may perform the role of an insulating layer in the structure in which the conductive adhesive layer 130 is disposed on the substrate 110.

The conductive adhesive layer 130 may be a layer having adhesiveness and conductivity, and thus, a conductive material and an adhesive material can be mixed on the conductive adhesive layer 130. Furthermore, the conductive adhesive layer 130 can have flexibility, thereby allowing a flexible function in the display device. For example, the conductive adhesive layer 130 may be an anisotropic conductive film (ACF), an anisotropic conductive paste, a solution containing conductive particles, and the like. The conductive adhesive layer 130 allows electrical interconnection in the z-direction passing through the thickness thereof, but may be configured as a layer having electrical insulation in the horizontal x-y direction thereof. Accordingly, the conductive adhesive layer 130 can be referred to as a z-axis conductive layer (however, hereinafter referred to as a "conductive adhesive layer").

The anisotropic conductive film includes an anisotropic conductive medium mixed with an insulating base member, and thus when heat and pressure are applied thereto, only a specific portion thereof has conductivity by the anisotropic conductive medium. Hereinafter, heat and pressure are applied to the anisotropic conductive film, but other methods may be also available for the anisotropic conductive film to partially have conductivity. The methods may include applying only either one of heat and pressure thereto, UV curing, and the like.

Furthermore, the anisotropic conductive medium may be conductive balls or particles. According to the drawing, in the present embodiment, the anisotropic conductive film includes an anisotropic conductive medium mixed with an insulating base member, and thus when heat and pressure are applied thereto, only a specific portion thereof has conductivity by the conductive balls. The anisotropic conductive film includes a core with a conductive material containing a plurality of particles coated by an insulating layer with a polymer material, and in this instance, it has conductivity by the core while breaking an insulating layer on a portion to which heat and pressure are applied. In this instance, a core may be transformed to implement a layer having both surfaces to which objects contact in the thickness direction of the film.

For a more specific example, heat and pressure are applied to an anisotropic conductive film as a whole, and electrical connection in the z-axis direction is partially formed by a height difference from a mating object adhered by using the anisotropic conductive film. In another example, an anisotropic conductive film may include a plurality of particles in which a conductive material is coated on insulating cores. In this instance, a portion to which heat and pressure are applied can be converted (pressed and adhered) to a conductive material to have conductivity in the thickness direction of the film. In still another example, it can be formed to have conductivity in the thickness direction of the film in which a conductive material passes through an insulating base member in the z-direction. In this instance, the conductive material may have a pointed end portion.

According to the drawing, the anisotropic conductive film may be a fixed array anisotropic conductive film (ACF) including conductive balls inserted into one surface of the insulating base member. More specifically, the insulating base member includes an adhesive material, and the conductive balls are intensively disposed at a bottom portion of the insulating base member, and when heat and pressure are applied thereto, the base member is modified along with the conductive balls, thereby having conductivity in the vertical direction thereof.

However, the embodiments are not limited to this, and the anisotropic conductive film can include conductive balls randomly mixed with an insulating base member or a form configured with a plurality of layers in which conductive balls are disposed at any one layer (double-ACF), and the like. The anisotropic conductive paste as a form coupled to a paste and conductive balls may be a paste in which conductive balls are mixed with an insulating and adhesive base material. Furthermore, a solution containing conductive particles may contain conductive particles or nano-particles.

Referring to the drawing again, the second electrode 140 is located at the insulating layer 160 to be separated from the auxiliary electrode 170. In other words, the conductive adhesive layer 130 is disposed on the insulating layer 160 located with the auxiliary electrode 170 and the second electrode 140. When the conductive adhesive layer 130 is formed in a state that the auxiliary electrode 170 and second electrode 140 are located, and then the semiconductor light emitting device 150 is connected thereto in a flip chip form with the application of heat and pressure, the semiconductor light emitting device 150 is electrically connected to the first electrode 120 and second electrode 140.

Referring to FIG. 4, the semiconductor light emitting device 150 may be a flip chip type semiconductor light emitting device. For example, the semiconductor light emitting device may include a p-type electrode 156, a p-type semiconductor layer 155 formed with the p-type electrode 156, an active layer 154 formed on the p-type semiconductor layer 155, an n-type semiconductor layer 153 formed on the active layer 154, and an n-type electrode 152 disposed to be separated from the p-type electrode 156 in the horizontal direction on the n-type semiconductor layer 153. In this instance, the p-type electrode 156 can be electrically connected to the welding portion by the conductive adhesive layer 130, and the n-type electrode 152 can be electrically connected to the second electrode 140.

Referring to FIGS. 2, 3A and 3B again, the auxiliary electrode 170 can be formed in an elongated manner in one direction to be electrically connected to a plurality of semiconductor light emitting devices 150. For example, the left and right p-type electrodes of the semiconductor light emitting devices 150 around the auxiliary electrode 170 can be electrically connected to one auxiliary electrode. More specifically, the semiconductor light emitting device 150 is pressed into the conductive adhesive layer 130, and through this, only a portion between the p-type electrode 156 and auxiliary electrode 170 of the semiconductor light emitting device 150 and a portion between the n-type electrode 152 and second electrode 140 of the semiconductor light emitting device 150 have conductivity, and the remaining portion does not have conductivity since there is no push-down of the semiconductor light emitting device. Furthermore, a plurality of semiconductor light emitting devices 150 constitute a light-emitting array, and a phosphor layer 180 is formed on the light-emitting array.

The light emitting device includes a plurality of semiconductor light emitting devices with different self luminance values. Each of the semiconductor light emitting devices 150 constitutes a sub-pixel, and is electrically connected to the first electrode 120. For example, there may exist a plurality of first electrodes 120, and the semiconductor light emitting devices are arranged in several rows, for instance, and each row of the semiconductor light emitting devices can be electrically connected to any one of the plurality of first electrodes.

Furthermore, the semiconductor light emitting devices may be connected in a flip chip form, and thus semiconductor light emitting devices can be grown on a transparent dielectric substrate. Furthermore, the semiconductor light emitting devices may be nitride semiconductor light emitting devices, for instance. The semiconductor light emitting device 150 has an excellent luminance characteristic, and thus it is possible to configure individual sub-pixels even with a small size thereof.

According to the drawing, a partition wall 190 can be formed between the semiconductor light emitting devices 150. In this instance, the partition wall 190 divides individual sub-pixels from one another, and is formed as an integral body with the conductive adhesive layer 130. For example, a base member of the anisotropic conductive film may form the partition wall when the semiconductor light emitting device 150 is inserted into the anisotropic conductive film.

Furthermore, when the base member of the anisotropic conductive film is black, the partition wall 190 has a reflective characteristics while at the same time increasing contrast with no additional black insulator. In another example, a reflective partition wall may be separately provided with the partition wall 190. In this instance, the partition wall 190 may include a black or white insulator according to the purpose of the display device. It thus can have an effect of enhancing reflectivity when the partition wall of the while insulator is used, and increase contrast while at the same time having reflective characteristics.

The phosphor layer 180 is located at an outer surface of the semiconductor light emitting device 150. For example, in one embodiment of the invention, the semiconductor light emitting device 150 is a blue semiconductor light emitting device that emits blue (B) light, and the phosphor layer 180 performs the role of converting the blue (B) light into the color of a sub-pixel. The phosphor layer 180 may be a red phosphor layer 181 or a green phosphor layer 182 constituting individual pixels. The phosphor layer 180 may be other color phosphor layers.

In other words, a red phosphor 181 capable of converting blue light into red (R) light can be deposited on the blue semiconductor light emitting device at a location implementing a red sub-pixel, and a green phosphor 182 capable of converting blue light into green (G) light may be deposited on the blue semiconductor light emitting device at a location implementing a green sub-pixel. Furthermore, only the blue semiconductor light emitting device can be used at a location implementing a blue sub-pixel. In this instance, the red (R), green (G) and blue (B) sub-pixels can implement one pixel. More specifically, one color phosphor can be deposited along each line of the first electrode 120. Accordingly, one line on the first electrode 120 can be an electrode controlling one color. In other words, red (R), green (B) and blue (B) can be sequentially disposed, thereby implementing sub-pixels.

However, the embodiments are not limited to this, and the semiconductor light emitting device 150 may be combined with a quantum dot (QD) instead of a phosphor to implement sub-pixels such as red (R), green (G) and blue (B). Furthermore, a black matrix 191 can be disposed between each phosphor layer to enhance contrast. In other words, the black matrix 191 can enhance the contrast of luminance. However, the embodiments are not limited to this, and another structure for implementing blue, red and green may be also applicable thereto.

Referring to FIG. 5A, each of the semiconductor light emitting devices 150 can be implemented with a high-power light emitting device that emits various lights including blue in which gallium nitride (GaN) is mostly used, and indium (In) and or aluminum (Al) are added thereto. In this instance, the semiconductor light emitting device 150 may be red, green and blue semiconductor light emitting devices, respectively, to implement each sub-pixel. For instance, red, green and blue semiconductor light emitting devices (R, G, B) are alternately disposed, and red, green and blue sub-pixels implement one pixel by means of the red, green and blue semiconductor light emitting devices, thereby implementing a full color display.

Referring to FIG. 5B, the semiconductor light emitting device may have a white light emitting device (W) provided with a yellow phosphor layer for each element. In this instance, a red phosphor layer 181, a green phosphor layer 182 and blue phosphor layer 183 may be provided on the white light emitting device (W) to implement a sub-pixel. Furthermore, a color filter repeated with red, green and blue on the white light emitting device (W) may be used to implement a sub-pixel.

Referring to FIG. 5C, it is possible to also have a structure in which a red phosphor layer 181, a green phosphor layer 182 and blue phosphor layer 183 may be provided on a ultra violet light emitting device (UV). Thus, the semiconductor light emitting device can be used over the entire region up to ultra violet (UV) as well as visible light, and ultra violet (UV) can be used as an excitation source.

Taking the present example into consideration again, the semiconductor light emitting device 150 is placed on the conductive adhesive layer 130 to configure a sub-pixel in the display device. The semiconductor light emitting device 150 has excellent luminance characteristics, and thus it is possible to configure individual sub-pixels even with a small size thereof. The size of the individual semiconductor light emitting device 150 may be less than 80 µm in the length of one side thereof, and formed with a rectangular or square shaped element. In an instance of a rectangular shaped element, the size thereof may be less than 20 x 80 µm.

Furthermore, even when a square shaped semiconductor light emitting device 150 with a length of side of 10 µm is used for a sub-pixel, it will exhibit a sufficient brightness for implementing a display device. Accordingly, for example, in the instance of a rectangular pixel in which one side of a sub-pixel is 600 µm in size, and the remaining one side thereof is 300 µm, a relative distance between the semiconductor light emitting devices becomes sufficiently large. Accordingly, in this instance, it is possible to implement a flexible display device having an HD image quality.

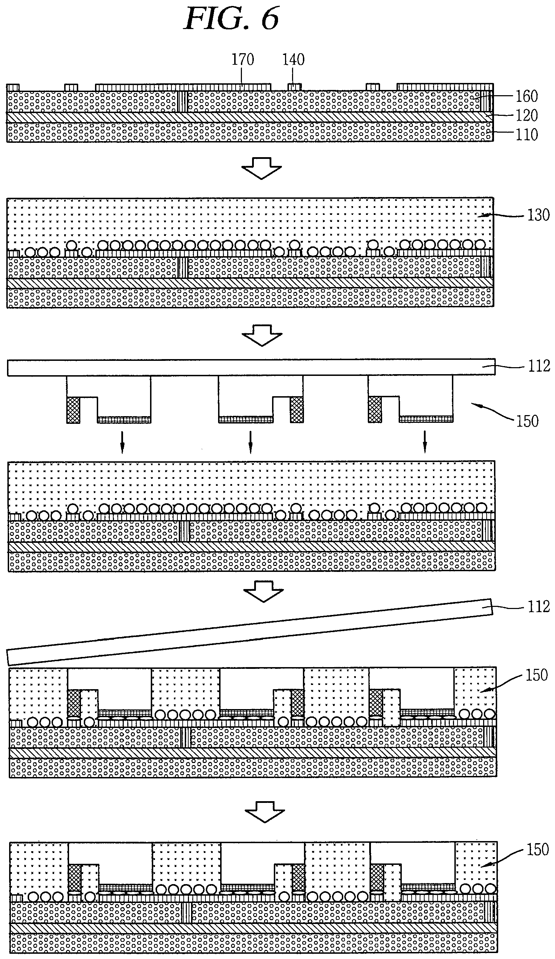

A display device using the foregoing semiconductor light emitting device will be fabricated by a novel type of fabrication method. Hereinafter, the fabrication method will be described with reference to FIG. 6. In particular, FIG. 6 is cross-sectional views illustrating a method of fabricating a display device using a semiconductor light emitting device as described herein.

Referring to the drawing, first, the conductive adhesive layer 130 is formed on the insulating layer 160 located with the auxiliary electrode 170 and second electrode 140. The insulating layer 160 is deposited on the first substrate 110 to form one substrate (or wiring substrate), and the first electrode 120, auxiliary electrode 170 and second electrode 140 are disposed at the wiring substrate. In this instance, the first electrode 120 and second electrode 140 can be disposed in a perpendicular direction to each other. Furthermore, the first substrate 110 and insulating layer 160 may contain glass or polyimide (PI), respectively, to implement a flexible display device. The conductive adhesive layer 130 may be implemented by an anisotropic conductive film, for example, and thus, an anisotropic conductive film may be coated on a substrate located with the insulating layer 160.

Next, a second substrate 112 located with a plurality of semiconductor light emitting devices 150 corresponding to the location of the auxiliary electrodes 170 and second electrodes 140 and constituting individual pixels is disposed such that the semiconductor light emitting device 150 faces the auxiliary electrode 170 and second electrode 140. In this instance, the second substrate 112 as a growth substrate for growing the semiconductor light emitting device 150 may be a sapphire substrate or silicon substrate.

The semiconductor light emitting device may have a gap and size capable of implementing a display device when formed in the unit of wafer, and thus effectively used for a display device. Next, the wiring substrate is thermally compressed to the second substrate 112. For example, the wiring substrate and second substrate 112 may be thermally compressed to each other by applying an ACF press head. The wiring substrate and second substrate 112 are bonded to each other using the thermal compression.

Only a portion between the semiconductor light emitting device 150 and the auxiliary electrode 170 and second electrode 140 may have conductivity due to the characteristics of an anisotropic conductive film having conductivity by thermal compression, thereby allowing the electrodes and semiconductor light emitting device 150 to be electrically connected to each other. At this time, the semiconductor light emitting device 150 may be inserted into the anisotropic conductive film, thereby forming a partition wall between the semiconductor light emitting devices 150.

Next, the second substrate 112 is removed. For example, the second substrate 112 may be removed using a laser lift-off (LLO) or chemical lift-off (CLO) method. Finally, the second substrate 112 is removed to expose the semiconductor light emitting devices 150 to the outside. Silicon oxide (SiOx) or the like may be coated on the wiring substrate coupled to the semiconductor light emitting device 150 to form a transparent insulating layer.

A phosphor layer can be formed on one surface of the semiconductor light emitting device 150. For example, the semiconductor light emitting device 150 may be a blue semiconductor light emitting device for emitting blue (B) light, and red or green phosphor for converting the blue (B) light into the color of the sub-pixel may form a layer on one surface of the blue semiconductor light emitting device.

The fabrication method or structure of a display device using the foregoing semiconductor light emitting device can be modified in various forms. For example, the foregoing display device may be applicable to a vertical semiconductor light emitting device. Hereinafter, the vertical structure will be described. Furthermore, according to the following modified example or embodiment, the same or similar reference numerals are designated to the same or similar configurations to the foregoing example, and the description thereof will be substituted by the earlier description.

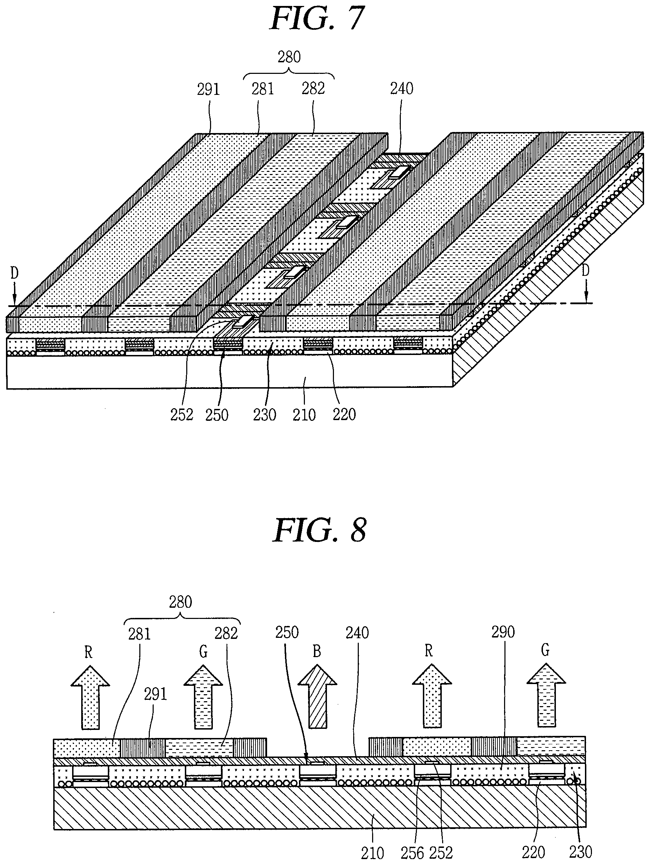

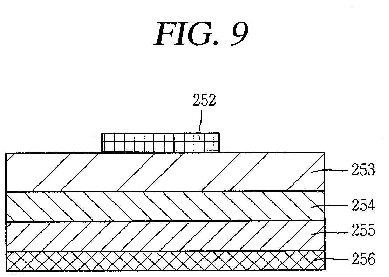

FIG. 7 is a perspective view illustrating a display device using a semiconductor light emitting device according to an illustrative embodiment useful for understanding the invention. FIG. 8 is a cross-sectional view taken along line D-D in FIG. 7, and FIG. 9 is a conceptual view illustrating a vertical type semiconductor light emitting device in FIG. 8. According to the drawings, the display device can use a passive matrix (PM) type of a vertical semiconductor light emitting device, but in other embodiments, an active matrix (AP) type of a vertical semiconductor light emitting device can be used.

As shown, the display device includes a substrate 210, a first electrode 220, a conductive adhesive layer 230, a second electrode 240 and a plurality of semiconductor light emitting devices 250. The substrate 210 as a wiring substrate disposed with the first electrode 220 may include polyimide (PI) to implement a flexible display device. In addition, any one may be used if it is an insulating and flexible material.

The first electrode 220 is located on the substrate 210, and formed as a bar elongated in one direction. The first electrode 220 can perform the role of a data electrode. The conductive adhesive layer 230 is formed on the substrate 210 located with the first electrode 220. Similarly to a display device to which a flip chip type light emitting device is applied, the conductive adhesive layer 230 can be an anisotropic conductive film (ACF), an anisotropic conductive paste, a solution containing conductive particles, and the like. However, the present embodiment illustrates an instance where the conductive adhesive layer 230 is implemented by an anisotropic conductive film.

When an anisotropic conductive film is located in a state that the first electrode 220 is located on the substrate 210, and then heat and pressure are applied to connect the semiconductor light emitting device 250 thereto, the semiconductor light emitting device 250 is electrically connected to the first electrode 220. At this time, the semiconductor light emitting device 250 is preferably disposed on the first electrode 220.

The electrical connection is generated because an anisotropic conductive film partially has conductivity in the thickness direction when heat and pressure are applied as described above. Accordingly, the anisotropic conductive film is partitioned into a portion having conductivity and a portion having no conductivity in the thickness direction thereof. Furthermore, the anisotropic conductive film contains an adhesive component, and thus the conductive adhesive layer 230 implements a mechanical coupling as well as an electrical coupling between the semiconductor light emitting device 250 and the first electrode 220.

Thus, the semiconductor light emitting device 250 is placed on the conductive adhesive layer 230, thereby configuring a separate sub-pixel in the display device. The semiconductor light emitting device 250 has excellent luminance characteristics, and thus it is possible to configure individual sub-pixels even with a small size thereof. The size of the individual semiconductor light emitting device 250 may be less than 80 µm in the length of one side thereof, and formed with a rectangular or square shaped element. In the instance of a rectangular shaped element, the size thereof may be less than 20 x 80 µm.

Further, the semiconductor light emitting device 250 may be of a vertical structure. A plurality of second electrodes 240 disposed in a direction crossed with the length direction of the first electrode 220, and electrically connected to the vertical semiconductor light emitting device 250 is located between vertical semiconductor light emitting devices.

Referring to FIG. 9, the vertical semiconductor light emitting device may include a p-type electrode 256, a p-type semiconductor layer 255 formed with the p-type electrode 256, an active layer 254 formed on the p-type semiconductor layer 255, an n-type semiconductor layer 253 formed on the active layer 254, and an n-type electrode 252 formed on the n-type semiconductor layer 253. In this instance, the p-type electrode 256 located at the bottom thereof can be electrically connected to the first electrode 220 by the conductive adhesive layer 230, and the n-type electrode 252 located at the top thereof can be electrically connected to the second electrode 240 which will be described later. The electrodes can also be disposed in the upward/downward direction in the vertical semiconductor light emitting device 250, thereby providing a great advantage capable of reducing the chip size.

Referring to FIG. 8, a phosphor layer 280 can be formed on one surface of the semiconductor light emitting device 250. For example, the semiconductor light emitting device 250 is a blue semiconductor light emitting device that emits blue (B) light, and the phosphor layer 280 for converting the blue (B) light into the color of the sub-pixel may be provided thereon. In this instance, the phosphor layer 280 may be a red phosphor 281 and a green phosphor 282 constituting individual pixels.

In other words, a red phosphor 281 capable of converting blue light into red (R) light can be deposited on the blue semiconductor light emitting device at a location implementing a red sub-pixel, and a green phosphor 282 capable of converting blue light into green (G) light can be deposited on the blue semiconductor light emitting device at a location implementing a green sub-pixel. Furthermore, only the blue semiconductor light emitting device can be used at a location implementing a blue sub-pixel. In this instance, the red (R), green (G) and blue (B) sub-pixels may implement one pixel.

However, another structure for implementing blue, red and green may be also applicable thereto as described above in a display device to which a flip chip type light emitting device is applied. Taking the present embodiment into consideration again, the second electrode 240 is located between the semiconductor light emitting devices 250, and electrically connected to the semiconductor light emitting devices 250. For example, the semiconductor light emitting devices 250 can be disposed in a plurality of rows, and the second electrode 240 is located between the rows of the semiconductor light emitting devices 250.

Since a distance between the semiconductor light emitting devices 250 constituting individual pixels is sufficiently large, the second electrode 240 can be located between the semiconductor light emitting devices 250. The second electrode 240 can be formed with an electrode having a bar elongated in one direction, and disposed in a perpendicular direction to the first electrode.

Furthermore, the second electrode 240 can be electrically connected to the semiconductor light emitting device 250 by a connecting electrode protruded from the second electrode 240. More specifically, the connecting electrode can be an n-type electrode of the semiconductor light emitting device 250. For example, the n-type electrode is formed with an ohmic electrode for ohmic contact, and the second electrode covers at least part of the ohmic electrode by printing or deposition. Through this, the second electrode 240 can be electrically connected to the n-type electrode of the semiconductor light emitting device 250.

According to the drawing, the second electrode 240 is located on the conductive adhesive layer 230. According to circumstances, a transparent insulating layer containing silicon oxide (SiOx) can be formed on the substrate 210 including the semiconductor light emitting device 250. When the transparent insulating layer is formed and then the second electrode 240 is placed thereon, the second electrode 240 is located on the transparent insulating layer. Furthermore, the second electrode 240 can be formed to be separated from the conductive adhesive layer 230 or transparent insulating layer.

If a transparent electrode such as indium tin oxide (ITO) is used to locate the second electrode 240 on the semiconductor light emitting device 250, the ITO material has a problem of bad adhesiveness with an n-type semiconductor. Accordingly, the second electrode 240 can be placed between the semiconductor light emitting devices 250, thereby obtaining an advantage in which the transparent electrode is not required. Accordingly, an n-type semiconductor layer and a conductive material having a good adhesiveness can be used as a horizontal electrode without being restricted by the selection of a transparent material, thereby enhancing the light extraction efficiency.

According to the drawing, a partition wall 290 can be formed between the semiconductor light emitting devices 250. In other words, the partition wall 290 can be disposed between the vertical semiconductor light emitting devices 250 to isolate the semiconductor light emitting device 250 constituting individual pixels. In this instance, the partition wall 290 performs the role of dividing individual sub-pixels from one another, and be formed as an integral body with the conductive adhesive layer 230. For example, a base member of the anisotropic conductive film may form the partition wall when the semiconductor light emitting device 250 is inserted into the anisotropic conductive film.

Furthermore, when the base member of the anisotropic conductive film is black, the partition wall 290 can have reflective characteristics while at the same time increasing contrast with no additional black insulator. In another example, a reflective partition wall can be separately provided with the partition wall 290. In this instance, the partition wall 290 may include a black or white insulator according to the purpose of the display device.

If the second electrode 240 is precisely located on the conductive adhesive layer 230 between the semiconductor light emitting devices 250, the partition wall 290 is located between the semiconductor light emitting device 250 and second electrode 240. Accordingly, individual sub-pixels may be configured even with a small size using the semiconductor light emitting device 250, and a distance between the semiconductor light emitting devices 250 may be relatively sufficiently large to place the second electrode 240 between the semiconductor light emitting devices 250, thereby having the effect of implementing a flexible display device having a HD image quality.

Furthermore, according to the drawing, a black matrix 291 can be disposed between each phosphor layer to enhance contrast. In other words, the black matrix 191 can enhance the contrast of luminance. The semiconductor light emitting devices 1050 can have an excellent luminance characteristic, and thus it is possible to configure individual sub pixels even with a small size thereof. The size of the individual semiconductor light emitting device 1050 may be 80 µm or less in length of one side thereof, and formed with a rectangular or square shaped element. For a rectangular shaped element, the size thereof may be 20 x 80 µm or less.

In the display device described above, the semiconductor light emitting device is so small that it is difficult to increase the luminance of the display device. This is because an area of the upper surface from which light is emitted in the semiconductor light emitting device is so small that there is limitations in increasing luminance. The present invention provides a display device employing the semiconductor light emitting device having a novel structure. A manufacturing method thereof will be described.

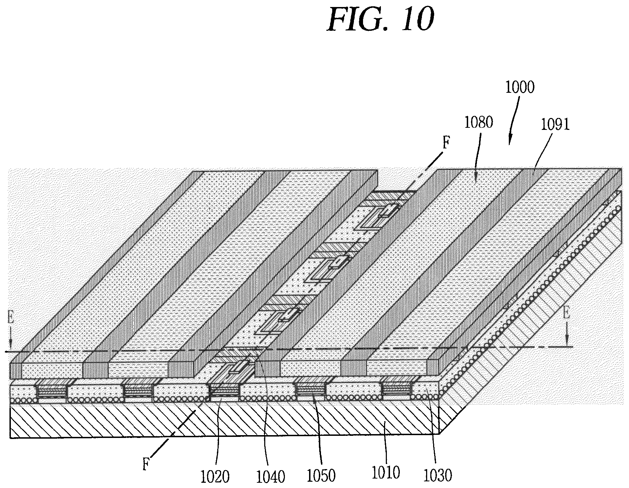

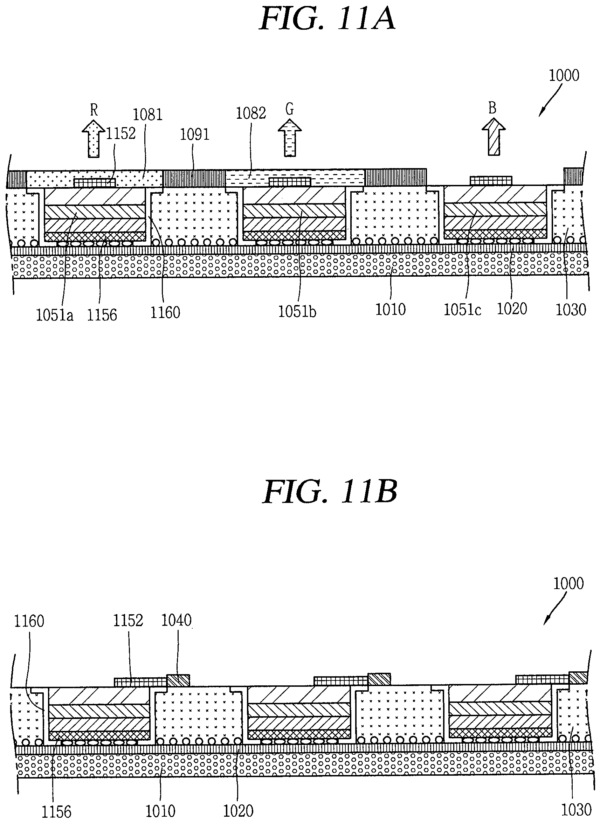

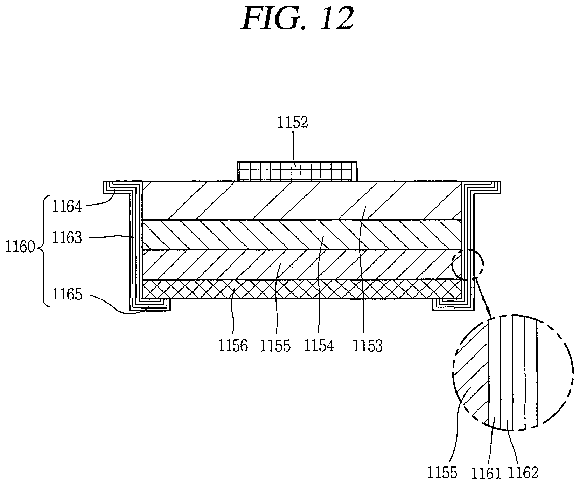

FIG. 10 is an enlarged view of a portion 'A' of FIG. 1, illustrating a semiconductor light emitting device having a novel structure according to an embodiment of the present invention, FIG. 11A is a cross-sectional view taken along line E-E of FIG. 10, FIG. 11B is a cross-sectional view taken along line F-F of FIG. 10, and FIG. 12 is a conceptual view illustrating the semiconductor light emitting device having a novel structure of FIG. 11A.

As illustrated in FIGS. 10, 11A, and 11B, a display device 1000 uses a passive matrix (PM) type vertical semiconductor light emitting device. However, the present invention is not limited thereto and is also applied to an active matrix (AM) type semiconductor light emitting device. As shown, the display device 1000 includes a substrate 1010, a first electrode 1020, a conductive adhesive layer 1030, a second electrode 1040, and a plurality of semiconductor light emitting devices 1050. Here, the first electrode 1020 and the second electrode 1040 may include a plurality of electrode lines.

The substrate 1010, a wiring substrate on which the first electrode 1020 is disposed, may include polyimide (PI) to implement a flexible display device. In addition, any substrate may be used as long as it is formed of a material having insulating properties and flexibility. The first electrode 1020 is positioned on the substrate 1010 and can be formed as an electrode having a bar shape extending in one direction. The first electrode 102 can serve as a data electrode.

The conductive adhesive layer 1030 is formed on the substrate 1010 where the first electrode 1020 is positioned. Like the aforementioned display device employing the flip chip type light emitting device, the conductive adhesive layer 1030 may be an anisotropy conductive film (ACF), an anisotropy conductive paste, or a solution containing conductive particles. However, in this embodiment, the conductive adhesive layer 1030 may be replaced with an adhesive layer. For example, when the first electrode 1020 is integrally formed with a conductive electrode of a semiconductor light emitting device, rather than being positioned on the substrate 1010, the adhesive layer may not need conductivity.

A plurality of second electrodes 1040, which are disposed in a direction intersecting a length direction of the first electrode 1020 and electrically connected to the semiconductor light emitting devices 1050 are positioned between the semiconductor light emitting devices. As illustrated, the second electrodes 1040 can be positioned on the conductive adhesive layer 1030. That is, the conductive adhesive layer 1030 is disposed between the wiring substrate and the second electrodes 1040. The second electrodes 1040 are in contact with the semiconductor light emitting devices so as to be electrically connected to the semiconductor light emitting devices 1050.

According to the structure described above, the plurality of semiconductor light emitting devices 1050 are coupled to the conductive adhesive layer 1030 and electrically connected to the first electrode 1020 and the second electrode 1040. According to circumstances, a transparent insulating layer including a silicon oxide (SiOx), or the like, can be formed on the substrate 1010 with the semiconductor light emitting devices 1050 formed thereon. When the second electrodes 1040 are positioned after the formation of the transparent insulating layer, the second electrodes 1040 are positioned on the transparent insulating layer. Also, the second electrodes 1040 can be spaced apart from the conductive adhesive layer 1030 or the transparent insulating layer.

As illustrated, the plurality of semiconductor light emitting devices 1050 may form a plurality of columns in a direction parallel to the plurality of electrode lines provided in the first electrode 1020. However, the present invention is not limited thereto. For example, the plurality of semiconductor light emitting devices 1050 may form a plurality of columns along the second electrodes 1040.

In addition, the display device 1000 includes a phosphor layer 1080 formed on one surface of the plurality of semiconductor light emitting devices 1050. For example, the semiconductor light emitting devices 1050 are blue semiconductor light emitting devices emitting blue (B) light, and the phosphor layer 1080 serves to convert the blue (B) light into a color of a unit pixel. The phosphor layer 1080 may be a red phosphor 1081 or a green phosphor 1082 forming an individual pixel. That is, in a position forming a red unit pixel, a red phosphor 1081 for converting blue light into red (R) light may be stacked on the blue semiconductor light emitting device 1051a, and in a position forming a green unit pixel, a green phosphor 1082 converting blue light into green (G) light may be stacked on the blue semiconductor light emitting device 1051b.

Also, in a portion forming a blue unit pixel, only the blue semiconductor light emitting device 1051c may be used alone in a portion forming a blue unit pixel. In this instance, red (R), green (G), and blue (B) unit pixels may form a single pixel. In more detail, a phosphor of one color may be stacked along each line of the first electrode 1020. Thus, in the first electrode 1020, one line may be an electrode controlling one color. That is, along the second electrodes 1040, red (R), green (G), and blue (B) may be sequentially disposed, by which unit pixels may be implemented. However, the present invention is not limited thereto and, instead of unit pixels the semiconductor light emitting device 1050 and a quantum dot (QD) may be combined to implement unit pixels emitting red (R) light, green (G) light, and blue (B) light.

Meanwhile, in order to enhance contrast of the phosphor layer 1080, the display device may further include a black matrix 1091 disposed between the phosphors. The black matrix 1091 can be formed by forming a gap between phosphor dots and filling the gap with a black material. Through this, the black matrix 1901 can absorb reflected ambient light and enhance contrast. The black matrix 1091 is positioned between phosphors along the first electrode 1020 in a direction in which the phosphor layer 1080 is stacked. In this instance, the phosphor layer is not formed in a position corresponding to the blue semiconductor light emitting device 1051, but the black matrix 1091 can be formed on both sides of a space in which the phosphor layer is not prevent (or on both sides of the blue semiconductor light emitting device 1051c).

Meanwhile, referring to the semiconductor light emitting device 1050 according to this embodiment, since electrodes are disposed up and down (or vertically) in the semiconductor light emitting device 1050, a chip size may be reduced. However, since the electrodes are disposed up and down, an area of a surface from which light is emitted in an upper side is reduced.

In this embodiment, when the semiconductor light emitting device has a size ranging from 10 to 100 micrometers in each dimension, a magnitude of light lost to a side surface of the semiconductor light emitting device increases to a nearly 1:1 ratio of light emitted from an upper side. Thus, the semiconductor light emitting device of this embodiment has a mechanism totally internally reflecting light from the side surface of the semiconductor light emitting device.

Referring to FIG. 12, for example, the semiconductor light emitting device 1050 includes a first conductivity type electrode 1156, a first conductivity type semiconductor layer 1155 on which the first conductivity type electrode 1156 is formed, an active layer 1154 formed on the first conductivity type semiconductor layer 1155, a second conductivity type semiconductor layer 1153 formed on the active layer 1154, and a second conductivity type electrode 1152 formed on the second conductivity type semiconductor layer.

The first conductivity type semiconductor layer 1155 and the second conductivity type semiconductor layer 1153 overlap each other, the second conductivity type electrode 1152 is disposed on an upper surface of the second conductivity type semiconductor layer 1153, and the first conductivity type electrode 1156 is disposed on a lower surface of the first conductivity type semiconductor layer 1155. In this instance, the upper surface of the second conductivity type semiconductor layer 1153 may be a surface of the second conductivity type semiconductor layer 1153 farthest from the first conductivity type semiconductor layer 1155 and the lower surface of the first conductivity type semiconductor layer 1155 may be a surface of the first conductivity type semiconductor layer 1155 farthest from the second conductivity type semiconductor layer 1153. Thus, the first conductivity type electrode 1156 and the second conductivity type electrode 1152 are disposed above and below with the first conductivity type semiconductor layer 1155 and the second conductivity type semiconductor layer 1153 interposed therebetween.

Referring to FIG. 12 together with FIGS. 10 through 11B, the lower surface of the first conductivity type semiconductor layer 1155 is a surface closest to the wiring substrate, and the upper surface of the second conductivity type semiconductor layer 1153 is a surface farthest from the wiring substrate. In more detail, the first conductivity type electrode 1156 and the first conductivity type semiconductor layer 1155 may be a p type electrode and a p type semiconductor layer, respectively, and the second conductivity type electrode 1152 and the second conductivity type semiconductor layer 1153 may be an n type electrode and an n type semiconductor layer, respectively. In this instance, the p type positioned in the upper portion can be electrically connected to the first electrode 1020 by the conductive adhesive layer 1030, and the n type electrode positioned in the lower portion can be electrically connected to the second electrode 1040. However, the present invention is not limited thereto and the first conductivity type may be an n type, and the second conductivity type may be a p type.

The semiconductor light emitting device includes a passivation layer 1160 formed to cover side surfaces of the first conductivity type semiconductor layer and the second conductivity type semiconductor layer 1153. Covering the side surfaces of the semiconductor light emitting device, the passivation layer 1160 serves to stabilize characteristics of the semiconductor light emitting device, and here, the passivation layer 1160 is formed of an insulating material. Since the first conductivity type semiconductor layer 1155 and the second conductivity type semiconductor layer 1153 are electrically disconnected by the passivation layer 1160, P type GaN and N type GaN of the semiconductor light emitting device may be insulated from each other.

As illustrated, the passivation layer 1160 includes a plurality of layers 1161 and 1162 having different refractive indices to reflect light emitted to side surfaces of the first conductivity type semiconductor layer 1155 and the second conductivity type semiconductor layer 1153. In the plurality of layers, a material having a relatively high refractive index and a material having a relatively low refractive index may be repeatedly stacked. The material having a high refractive index may include at least one of SiN, TiO₂, Al₂O₃, and ZrO₂, the material having a low refractive index may include SiO₂, and a difference between the material having a high refractive index and the material having a low refractive index may be equal to or greater than 0.3. For example, a difference between the material having a high refractive index and the material having a low refractive index may be range from 0.3 to 0.9.

Light efficiency of the semiconductor light emitting device such as a light emitting diode (LED) is determined by internal quantum efficiency and light extraction efficiency. When light generated in a multi-quantum well within the LED is emitted to outside, a critical angle at which light is emitted is reduced due to a difference between a refractive index of gallium nitride (refractive index: 2.4) and air (refractive index: 1), causing loss of light.

In a micro-scale semiconductor light emitting device, since devices are separated, if light released outwardly from the side surfaces of the devices is collected, an increase in light extraction efficiency can be anticipated. In on embodiment of the present invention, dielectric films different in refractive index are repeatedly stacked in the passivation layer 1160 of the semiconductor light emitting device, whereby an output angle of light is adjusted to collect light to the interior of the devices. In more detail, the passivation layer 1160 has a structure in which a material having a low refractive index (SiO2, or the like) and a material having a high refractive index (SiN, TiO₂, Al₂O₃, ZrO₂, etc.) are repeatedly stacked in turns. That is, using two materials whose difference in refractive index is equal to or greater than 0.3, a path of light generated within the devices is changed to suppress loss of light released outwardly from the side surfaces of the devices.

As illustrated, a layer (i.e., a first layer) 1161 having a relatively low refractive index, among the plurality of layers 1161 and 1162), is in direct contact with the side surfaces, and a material having a low refractive index provided in the first layer 1161 is formed to have a refractive index lower than that of the first conductivity type semiconductor layer. Meanwhile, a material provided in a layer (i.e., a second layer) 1162 having a high refractive index may be a material having a refractive index higher than that of the first layer 1161.

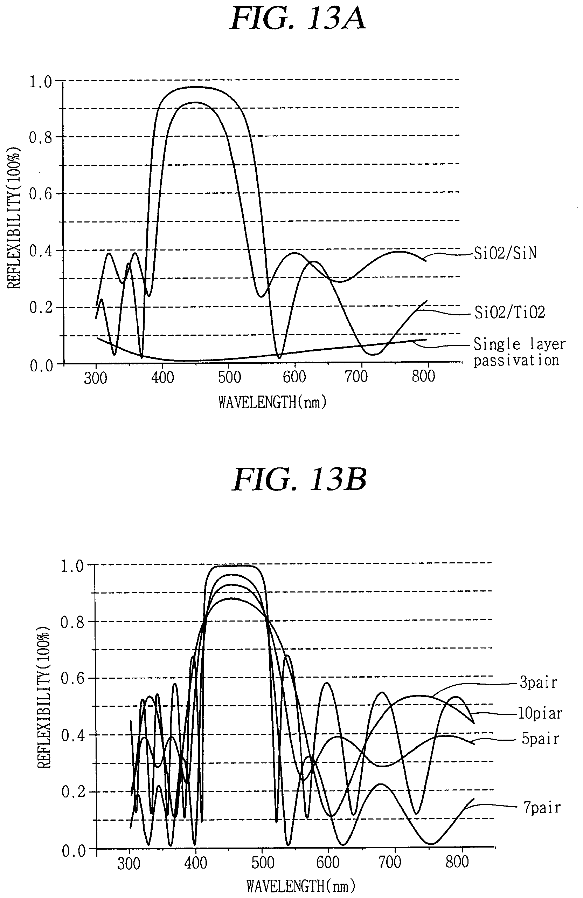

Thus, when the material having a high refractive index and the material having a low refractive index are repeatedly deposited periodically using the principle of dielectric HR multilayers, constructive interference occurs in a specific wavelength band due to interference of incident light, obtaining a high refraction (HR) effect. In this instance, referring to FIG. 13A illustrating a graph of reflectivity according to materials of the passivation layer, it can be seen that, as the difference in refractive index between the first and second layers increases, reflectivity is higher. Also, referring to FIG. 13B illustrating a graph of reflectivity according to the repeated stacking number of a plurality of layers, it can be seen that, as the number of deposited thin films increases, reflectivity of thin films is higher in a specific wavelength band.

FIG. 13A shows a difference in reflectivity in a specific wavelength band when SiO₂ (refractive index in a wavelength of 450nm is 1.5) was used as a material having a low refractive index and SiN (refractive index in a wavelength of 450 nm is 2) and TiO₂ (refractive index in a wavelength of 450 nm is 2.3) were used as materials having a high refractive index, compared with a case of single thin film passivation. When the SiO₂ single thin film was used, reflection rarely occurred in the wavelength of 450 nm, while when the SiO₂/SiN thin film was used, about 90% reflectivity was obtained in the wavelength of 450 nm, and when the SiO₂/TiO₂ thin film was used, reflectivity of about 98% was obtained in the same wavelength.

In FIG. 13B, there are differences in reflectivity according to the stacking number of thin films when the SiO₂/SiN thin film was used, and it can be seen that, as the number of thin films increases, reflectivity is higher. When the material of the dielectric film used as a passivation layer and the stacking number of deposited thin films are adjusted, lateral reflectivity equal to or greater than 98% may be obtained. That is, reflection characteristics better than that of a metal reflective film such as silver (Ag) or aluminum (Al) can be obtained.

Referring to FIGS. 10, 11A and 11B, the display device 1000 includes the phosphor layer 1080 (see FIG. 10) formed on one surface of the plurality of semiconductor light emitting devices 1050. In this instance, light output from the semiconductor light emitting devices 1050 is excited using phosphors to implement red (R) and green (G). Also, the aforementioned black matrices 191, 291, and 1091 (see FIGS. 3B, 8, and 11B) serve as barrier ribs preventing color mixture between the phosphors.

Referring to FIG. 12 together with FIGS. 10, 11A, and 11B, at least a portion of the passivation layer 1160 reflects light from a lower side of the phosphor layer 1080. The passivation layer 1160 includes a body portion 1163 and a protrusion portion 1164. The body portion 1163 is a portion covering side surfaces of the first conductivity type semiconductor layer 1155 and the second conductivity type semiconductor layer 1153, and extending in a thickness direction of the display device. The protrusion portion 1164 protrudes in a direction intersecting the body portion 1163 from one end of the body portion 1163. The protrusion portion is disposed to overlap the phosphor layer 1080 disposed to cover the plurality of semiconductor light emitting devices.

Also, the protrusion portion 1164 has an upper surface coplanar with the surface of the second conductivity type semiconductor layer (i.e., the upper surface of the second conductivity type semiconductor layer 1153) on which the second conductivity type electrode 1152 is formed. When light emitted from the upper surface of the second conductivity type semiconductor layer is reflected within the phosphor layer 1080 so as to move toward the conductive adhesive layer 1030, the light is reflected upwardly by the protrusion portion 1164. According to this structure, luminance of the display device may further increase.

Also, the passivation layer 1160 may include an extending portion 1165 extending from the other end of the body portion 1163 in a direction opposite to the protrusion portion 1164. The extending portion 1165 can be formed to cover at least a portion of the first conductivity type electrode 1156, whereby a reflective layer reflecting light together with the first conductivity type electrode 1156 from a lower side of the semiconductor light emitting device. According to the structure of the novel display device described above, luminance is enhanced.

A panel using the semiconductor light emitting device of the novel display device was manufactured in actuality and an increase in a light output was checked. SiO2 was used as a material having a low refractive index, SiN was used as a material having a high refractive index, and reflectivity of the side surface of the device was anticipated as 90%. A size of the device was 20 um in width and 50 um in length. The device was manufactured as a panel in which single passivation was used in a half and the proposed structure of this_embodiment was applied to another half, and wall plug efficiency (WPE) was compared. According to the result of measuring luminance of the panel, it was confirmed that WPE was improved by about 12%.

Also, in this embodiment, since the passivation layer includes a plurality of layers, a short circuit between conductive electrodes of the semiconductor light emitting device due to generation of a pin hole when a dielectric film is deposited is solved. In case of using a passivation film of a single thin film, particles are generated during a deposition process to generate a small hole in the thin film, and in this instance, it is impossible for the device to operate, but in this embodiment, such a problem is solved. Also, when the number of pixels of a display increases, crosstalk that light is partially emitted even from a deactivated pixel (or an OFF pixel) may be problematic. According to the structure proposed in this embodiment, a leakage current to a neighbor chip may be limited, implementing sharp image quality in a high resolution display.

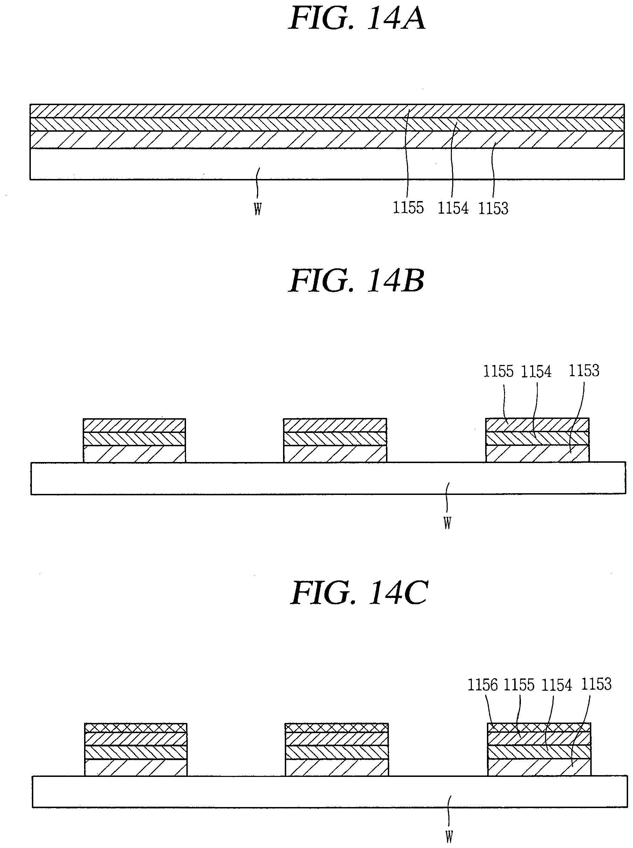

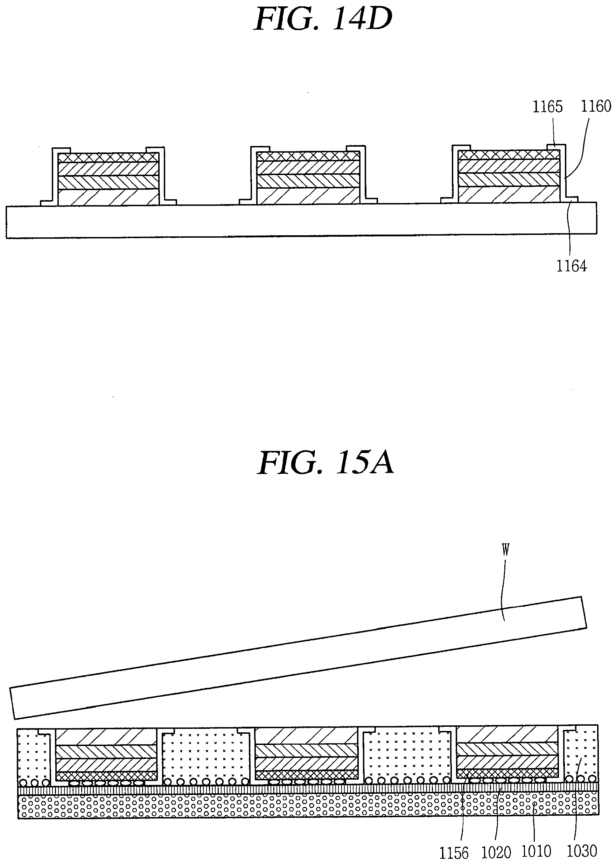

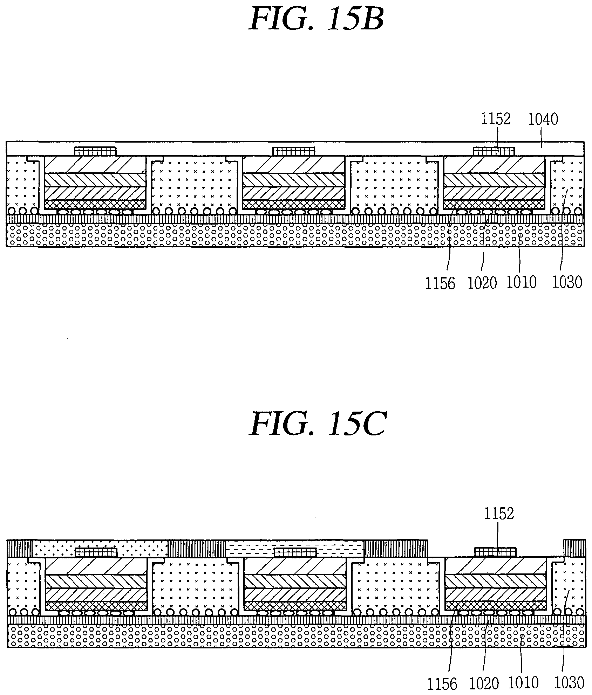

Hereinafter, a method for manufacturing the novel structure of the display device described above will be described in detail with reference to the accompanying drawings. FIGS. 14A, 14B, 14C, 14D, 15A, 15B, and 15C are cross-sectional views illustrating a method for manufacturing a display device .

First, according to the manufacturing method, a second conductivity type semiconductor layer 1153, an active layer 1154, and a first conductivity type semiconductor layer are grown on a growth substrate (or a semiconductor wafer). After the second conductivity type semiconductor layer 1153 is grown, the active layer 1154 is subsequently grown on the first conductivity type semiconductor layer 1152, and thereafter, the first conductivity type semiconductor layer 1155 is grown on the active layer 1154. Thus, when the second conductivity type semiconductor layer 1153, the active layer 1154, and the first conductivity type semiconductor layer 1155 are sequentially grown, a stacking structure of the second conductivity type semiconductor layer 1153, the active layer 1154, and the first conductivity type semiconductor layer 1155 is formed.

The growth substrate W can be formed to include a material having light-transmissive qualities, for example, any one of sapphire (Al₂O₃), GaN, ZnO, and AlO, but the present invention is not limited thereto. Also, the growth substrate W can be formed of a material appropriate for growing a semiconductor material, i.e., a carrier wafer. The growth substrate W may also be formed of a material having excellent thermal conductivity. For example, the growth substrate may be at least any one of a SiC, Si, GaAs, GaP, InP, and Ga₂O substrate having high thermal conductivity compared with a sapphire (Al₂O₃) substrate. And, the growth substrate may be a conductive substrate or an insulating substrate.

The second conductivity type semiconductor layer 1153 may be an n type semiconductor layer and may be a nitride semiconductor layer such as n-GaN. Thereafter, an etching process is performed to separate the p type semiconductor and the n type semiconductor and form a plurality of semiconductor light emitting devices isolated on the substrate. For example, referring to FIG. 14B, at least portions of the first conductivity type semiconductor layer 1155, the active layer 1154, and the second conductivity type semiconductor layer 1153 are etched to form a plurality of semiconductor light emitting devices isolated on the substrate (please refer to FIG. 14B). In this instance, the etching may be performed until when the substrate is exposed. In another example, etching may be performed to reach a state in which a portion of the second conductivity type semiconductor layer 1153 is left between the semiconductor light emitting devices.

Thereafter, at least one conductivity type electrode is formed on the semiconductor light emitting devices (FIG. 14C). In more detail, a first conductivity type electrode 1156 is formed on one surface of the first conductivity type semiconductor layer 1155. That is, after the array of semiconductor light emitting devices are formed on the substrate, the first conductivity type electrode 1156 is stacked on the first conductivity type semiconductor layer 1155.

Thereafter, a passivation layer 1160 is formed to cover side surfaces of the semiconductor light emitting devices (FIG. 14D). The passivation layer 1160 may include a plurality of layers having different refractive indices to reflect light emitted to the side surfaces. The plurality of layers can be formed by repeatedly stacking a material having a relatively low refractive index and a material having a relatively high refractive index. Details of the passivation layer 1160 will be replaced by the details described above with reference to FIGS. 10 through 12. In this instance, a protrusion portion 1164 of the passivation layer 160 can be formed in a space between the semiconductor light emitting devices on the substrate. Also, an extending portion 1165 of the passivation layer 1160 may be configured to cover at least a portion of the first conductivity type electrode 1156.

According to the process, a structure in which the passivation layer 160 reflects light emitted from each of the semiconductor light emitting devices may be implemented. Thereafter, the semiconductor light emitting devices with the passivation layer formed thereon are connected to a wiring substrate, and the substrate is removed. For example, the semiconductor light emitting devices may be coupled to the wiring substrate using a conductive adhesive layer, and the growth substrate is removed (FIG. 15A). The wiring substrate may be in a state in which the first electrode 1020 is formed, and the first electrode 1020, as a lower wiring, is electrically connected to the first conductivity type electrode 1156 by a conductive ball, or the like, within the conductive adhesive layer 1030.

Thereafter, after the second conductivity type electrode 1152 is deposited on the second conductivity type semiconductor layer 1153 in each of the light emitting devices, a second electrode 1040 connecting the second conductivity type electrodes 1152 of the light emitting devices (FIG. 15B), and a phosphor layer 1080 is formed to cover the semiconductor light emitting devices (FIG. 15C). The second electrode 1040, as an upper wiring, is directly connected to the second conductivity type electrode 1152, and a protrusion portion 1164 of the passivation layer 1160 is disposed below the phosphor layer 1080.

According to the manufacturing method described above, since light reflection is induced at the side surfaces of the semiconductor light emitting devices by the plurality of layers having different refractive indices, luminance of the display device may be enhanced. Meanwhile, the display device using the semiconductor light emitting devices described above may be modified variously. Modifications thereof will be described hereinafter.

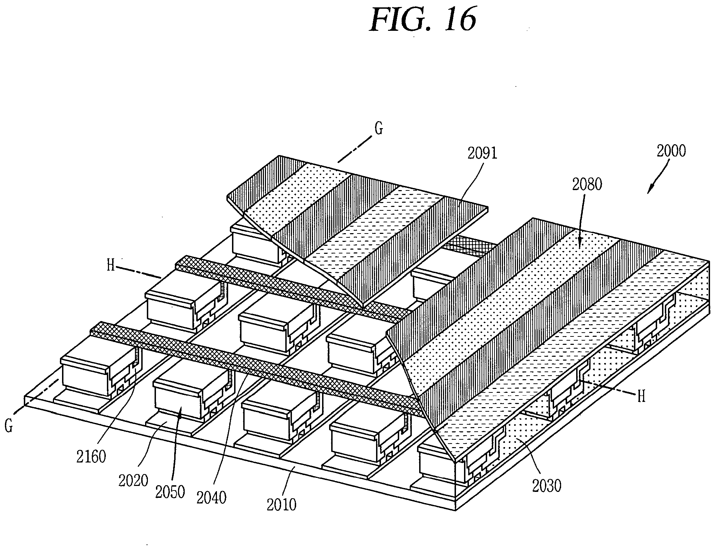

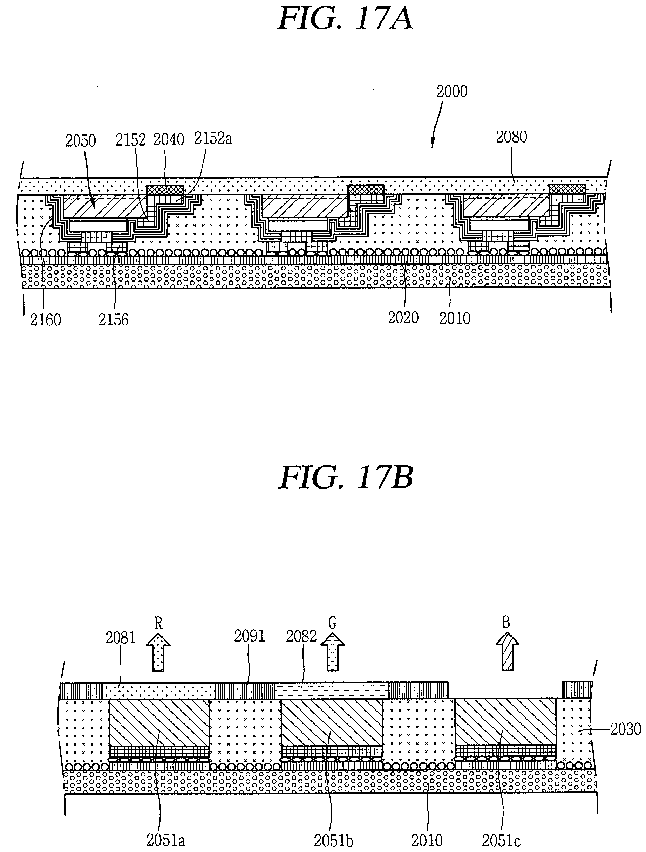

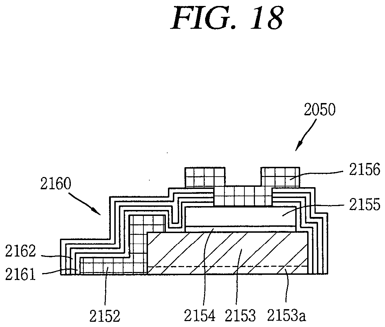

FIG. 16 is an enlarged view of a portion 'A' of FIG. 1, illustrating another embodiment not part of the present invention, FIG. 17A is a cross-sectional view taken along line G-G of FIG. 15, FIG. 17B is a cross-sectional view taken along line H-H of FIG. 15, and FIG. 18 is a conceptual view illustrating a flip chip type semiconductor light emitting device of FIG. 17A.

As illustrated in FIGS. 16, 17A, 17B, and 18, as a display device 2000 using a semiconductor light emitting device, a display device 2000 using a passive matrix (PM) type semiconductor light emitting device is illustrated. However, the embodiment described hereinafter may also be applied to an active matrix (AM) type semiconductor light emitting device.

The display device 2000 includes a substrate 2010, a first electrode 2020, a conductive adhesive layer 2030, a second electrode 2040, and a plurality of semiconductor light emitting devices 2050. Here, the first electrode 2020 and the second electrode 2040 may include a plurality of electrode lines. The substrate 2010, a wiring substrate on which the first electrode 2020 is disposed, may include polyimide (PI) to implement a flexible display device. In addition, any substrate may be used as long as it is formed of a material having insulating properties and flexibility. The first electrode 2020 is positioned on the substrate 2010 and can be formed as an electrode having a bar shape extending in one direction. The first electrode 202 may be configured to serve as a data electrode.

The conductive adhesive layer 2030 is formed on the substrate 2010 where the first electrode 2020 is positioned. Like the aforementioned display device employing the flip chip type light emitting device, the conductive adhesive layer 2030 may be an anisotropy conductive film (ACF), an anisotropy conductive paste, or a solution containing conductive particles. However, in this embodiment, the conductive adhesive layer 2030 may be replaced with an adhesive layer. For example, when the first electrode 2020 is integrally formed with a conductive electrode of a semiconductor light emitting device, rather than being positioned on the substrate 2010, the adhesive layer may not need conductivity.

A plurality of second electrodes 2040, which are disposed in a direction intersecting a length direction of the first electrode 2020 and electrically connected to the semiconductor light emitting devices 2050 are positioned between the semiconductor light emitting devices. As illustrated, the second electrodes 2040 may be positioned on the conductive adhesive layer 2030. That is, the conductive adhesive layer 2030 is disposed between the wiring substrate and the second electrodes 2040. The second electrodes 2040 may be in contact with the semiconductor light emitting devices so as to be electrically connected to the semiconductor light emitting devices 2050. According to the structure described above, the plurality of semiconductor light emitting devices 2050 are coupled to the conductive adhesive layer 2030 and electrically connected to the first electrode 2020 and the second electrode 2040.

According to circumstances, a transparent insulating layer including a silicon oxide (SiOx), or the like, can be formed on the substrate 2010 with the semiconductor light emitting devices 2050 formed thereon. In a case in which the second electrodes 2040 are positioned after the formation of the transparent insulating layer, the second electrodes 2040 are positioned on the transparent insulating layer. Also, the second electrodes 2040 can be formed to be spaced apart from the conductive adhesive layer 2030 or the transparent insulating layer.

As illustrated, the plurality of semiconductor light emitting devices 2050 may form a plurality of columns in a direction parallel to the plurality of electrode lines provided in the first electrode 2020. However, the plurality of semiconductor light emitting devices 2050 may form a plurality of columns along the second electrodes 2040.

In addition, the display device 2000 may further include a phosphor layer 2080 formed on one surface of the plurality of semiconductor light emitting devices 2050. For example, the semiconductor light emitting devices 2050 are blue semiconductor light emitting devices emitting blue (B) light, and the phosphor layer 2080 serves to convert the blue (B) light into a color of a unit pixel. The phosphor layer 2080 may be a red phosphor 2081 or a green phosphor 2082 forming an individual pixel. That is, in a position forming a red unit pixel, a red phosphor 2081 for converting blue light into red (R) light may be stacked on the blue semiconductor light emitting device 2051a, and in a position forming a green unit pixel, a green phosphor 2082 converting blue light into green (G) light may be stacked on the blue semiconductor light emitting device 2051b.

Also, in a portion forming a blue unit pixel, only the blue semiconductor light emitting device 2051c may be used alone in a portion forming a blue unit pixel. In this instance, red (R), green (G), and blue (B) unit pixels may form a single pixel. In more detail, a phosphor of one color may be stacked along each line of the first electrode 2020. Thus, in the first electrode 2020, one line may be an electrode controlling one color. That is, along the second electrodes 2040, red (R), green (G), and blue (B) may be sequentially disposed, by which unit pixels may be implemented. However, instead of unit pixels the semiconductor light emitting device 2050 and a quantum dot (QD) may be combined to implement unit pixels emitting red (R) light, green (G) light, and blue (B) light.

Meanwhile, in order to enhance contrast of the phosphor layer 2080, the display device may further include a black matrix 2091 disposed between the phosphors. The black matrix 2091 can be formed by forming a gap between phosphor dots and filling the gap with a black material. Through this, the black matrix 2901 may absorb reflected ambient light and enhance contrast. The black matrix 2091 is positioned between phosphors along the first electrode 2020 in a direction in which the phosphor layer 2080 is stacked. In this instance, the phosphor layer is not formed in a position corresponding to the blue semiconductor light emitting device 2051, but the black matrix 2091 can be formed on both sides of a space in which the phosphor layer is not prevent (or on both sides of the blue semiconductor light emitting device 2051c).

Meanwhile, referring to the semiconductor light emitting device 2050 according to this embodiment, since electrodes are disposed up and down (or vertically) in the semiconductor light emitting device 2050, a chip size may be reduced. However, although the electrodes are disposed up and down, the semiconductor light emitting device according to this embodiment may be a flip chip type light emitting device.

Referring to FIG. 18, for example, the semiconductor light emitting device 2050 includes a first conductivity type electrode 2156, a first conductivity type semiconductor layer 2155 on which the first conductivity type electrode 2156 is formed, an active layer 2154 formed on the first conductivity type semiconductor layer 2155, a second conductivity type semiconductor layer 2153 formed on the active layer 2154, and a second conductivity type electrode 2152 formed on the second conductivity type semiconductor layer.

In more detail, the first conductivity type electrode 2156 and the first conductivity type semiconductor layer 2155 may be a p type electrode and a p type semiconductor layer, respectively, and the second conductivity type electrode 2152 and the second conductivity type semiconductor layer 2153 may be an n type electrode and an n type semiconductor layer, respectively. In this instance, the p type positioned in the upper portion can be electrically connected to the first electrode 2020 by the conductive adhesive layer 2030, and the n type electrode positioned in the lower portion can be electrically connected to the second electrode 2040. However, the first conductivity type may be an n type, and the second conductivity type may be a p type.

In more detail, the first conductivity type electrode 2156 is formed on one surface of the first conductivity type semiconductor layer 2155, the active layer 2154 is formed between the other surface of the first conductivity type semiconductor layer 2155 and one surface of the second conductivity type semiconductor layer 2153, and the second conductivity type electrode 2152 is formed on one surface of the second conductivity type semiconductor layer 2153.

In this instance, the second conductivity type can be disposed on one surface of the second conductivity type semiconductor layer 2153, and an undoped semiconductor layer 2153a can be formed on the other surface of the second conductivity type semiconductor layer 2153. Also, the first conductivity type electrode 2156 and the second conductivity type electrode 2152 can be formed to have a difference in height in a width direction and vertical direction in positions of the semiconductor light emitting device spaced apart from one another in the width direction.

Using the difference in height, the second conductivity type electrode 2152 is formed on the second conductivity type semiconductor layer 2153 and disposed to be adjacent to the second electrode 2040 positioned above the semiconductor light emitting device. For example, at least a portion of the second conductivity type electrode 2152 protrudes in the width direction from a side surface of the second conductivity type semiconductor layer 2153 (or from a side surface of the undoped semiconductor layer 2153a). Thus, since the second conductivity type electrode 2152 protrudes from the side surface, the second conductivity type electrode 2152 may be exposed to an upper side of the semiconductor light emitting device. Accordingly, the second conductivity type electrode 2152 is disposed in a position overlapping the second electrode 2040 disposed above the conductive adhesive layer 2030.

In more detail, the semiconductor light emitting device includes a protrusion portion 2152a extending from the second conductivity type electrode 2152, and protruding from the side surface of each of the plurality of semiconductor light emitting devices. In this instance, with respect to the protrusion portion 2152a, it may be described such that the first conductivity type electrode 2156 and the second conductivity type electrode 2152 are disposed in positions spaced apart in the protrusion direction of the protrusion portion 2152a and formed to have a difference in height in a direction perpendicular to the protrusion direction.

The protrusion portion 2152a may extend laterally from one surface of the second conductivity type semiconductor layer 2153, and extend to the upper surface of the second conductivity type semiconductor layer 2153, specifically, to the undoped semiconductor layer 2153a. The protrusion portion 2152a protrudes from the side surface of the undoped semiconductor layer 2153a in the width direction. Thus, the protrusion portion 2152a can be electrically connected to the second electrode 2040 at the opposite side of the first conductivity type electrode with respect to the second conductivity type semiconductor layer.

The structure including the protrusion portion 2152a may be a structure capable of making the use of advantages of the horizontal type semiconductor light emitting device and the vertical type semiconductor light emitting device. Meanwhile, in the undoped semiconductor layer 2153a, fine recesses can be formed on an upper surface farthest from the first conductivity type electrode 2156 through roughing. Also, the semiconductor light emitting device 2050 includes a passivation layer formed to cover side surfaces of the first conductivity type semiconductor layer 2155 and the second conductivity type semiconductor layer 2153.

Covering the side surfaces of the semiconductor light emitting device, the passivation layer 2160 serves to stabilize characteristics of the semiconductor light emitting device, and here, the passivation layer 2160 is formed of an insulating material. Since the first conductivity type semiconductor layer 2155 and the second conductivity type semiconductor layer 2153 are electrically disconnected by the passivation layer 2160, P type GaN and N type GaN of the semiconductor light emitting device may be insulated from each other. As illustrated, the passivation layer 2160 may include a plurality of layers 2161 and 2162 having different refractive indices to reflect light emitted to side surfaces of the first conductivity type semiconductor layer 2155 and the second conductivity type semiconductor layer 2153.

In the plurality of layers, a material having a relatively high refractive index and a material having a relatively low refractive index may be repeatedly stacked. The material having a high refractive index may include at least one of SiN, TiO₂, Al₂O₃, and ZrO₂, the material having a low refractive index may include SiO₂, and a difference between the material having a high refractive index and the material having a low refractive index may be equal to or greater than 0.3. For example, a difference between the material having a high refractive index and the material having a low refractive index may be range from 0.3 to 0.9.

Details as described above with reference to FIGS. 10 through 12 may be applied to the passivation layer 2160, and thus, a description of the passivation layer 2160 are omitted. The passivation layer 2160 can be formed to cover portions of the first conductivity type semiconductor layer together with the second conductivity type electrode 2152.

In this instance, the second conductivity type electrode 2152 and the active layer 2154 are formed on one surface of the second conductivity type semiconductor layer 2153, and are spaced apart from each other with the passivation layer 2160 interposed therebetween. Here, one direction (or a horizontal direction) may be a width direction of the semiconductor light emitting device, and a vertical direction may be a thickness direction of the semiconductor light emitting device.

Also, in the first conductivity type semiconductor layer 2155, the first conductivity type electrode 2156 can be formed in a portion exposed without being covered by the passivation layer 2160. Thus, the first conductivity type electrode 2156 may penetrate through the passivation layer 2160 so as to be exposed to the outside. Thus, since the first conductivity type electrode 2156 and the second conductivity type electrode 2152 are spaced apart by the passivation layer 2160 the n type electrode and the p type electrode of the semiconductor light emitting device may be insulated.

According to the structure described above, the passivation layer 2160 for lateral reflection may be implemented in the flip chip type semiconductor light emitting device in which electrodes are disposed up and down, and thus, luminance of the display device may be increased. As described above, in the display device light may be induced to be reflected from the side surfaces of the semiconductor light emitting devices by the plurality of layers having different refractive indices. Accordingly, light emitted from the side surfaces of the semiconductor light emitting devices may be induced upwardly. In particular, in a small semiconductor light emitting device, a proportion of light emitted laterally increases, and thus, luminance of the display device may be significantly enhanced through the total internal reflection.

Also, in the present embodiment, since the total internal reflection function is provided to the passivation layer, luminance of the display device may be enhanced in spite of the simple technique. Also, since the passivation layer includes a plurality of layers, a short circuit between conductive electrodes of the semiconductor light emitting device due to generation of a pin hole when a dielectric film is deposited is solved. The invention is defined by the appended claims.

## Claims

1. A display device, comprising:
a substrate (1010) including a plurality of first electrodes (1020);
a plurality of semiconductor light emitting devices (1050) mounted on the substrate (1010) and electrically connected to the first electrodes (1020);
a plurality of second electrodes (1040) intersecting the first electrodes (1020) and electrically connected to the semiconductor light emitting devices (1050) and being positioned between the semiconductor light emitting devices (1050);
a conductive adhesive layer (1030) disposed between the substrate (1010) and the second electrodes (1040) and electrically connecting the semiconductor light emitting devices (1050) to the first electrodes (1020), and
a phosphor layer (1080) formed on one surface of the plurality of semiconductor light emitting devices (1050);
wherein the semiconductor light emitting devices (1050) comprise:
a first conductivity type semiconductor layer (1155);
a first conductivity type electrode (1156) disposed on the first conductivity type semiconductor layer (1155);
a second conductivity type semiconductor layer (1153) overlapping the first conductivity type semiconductor layer (1155);
a second conductivity type electrode (1152) disposed on the second conductivity type semiconductor layer (1153); and
a passivation layer (1160) including a plurality of layers (1161, 1162) having different refractive indices,
**characterized in that** the passivation layer further includes:
a body portion (1163) covering side surfaces of the first and second conductivity type semiconductor layers (1153, 1155) to reflect light emitted to side surfaces of the semiconductor light emitting device (1050), and
a protrusion portion (1164) protruding in a direction intersecting the body portion (1163) from one end of the body portion (1163), wherein
the protrusion portion (1164) has an upper surface coplanar with an upper surface of the second conductivity type semiconductor layer (1153),
the protrusion portion (1164) overlaps the phosphor layer (1080) covering the semiconductor light emitting devices (1050), and the protrusion portion (1164) being configured in order that light emitted from the upper surface of the second conductivity type semiconductor layer (1153) and reflected within the phosphor layer (1080) so as to move toward the conductive adhesive layer (1030) is reflected upwardly by the protrusion portion (1164).

2. The display device of claim 1, wherein the plurality of layers of the passivation layer (1160) include a first material layer (1161) having a relatively low refractive index and a second material layer (1162) having a relatively high refractive index repeatedly stacked on one another.

3. The display device of claim 2, wherein the second material layer (1162) having the relatively high refractive index includes at least one of SiN, TiO₂, Al₂O₃, and ZrO₂.

4. The display device of any one of claims 2 to 3, wherein the first material layer (1161) having the relatively low refractive index is in direct contact with the side surfaces.

5. The display device of any one of claims 2 to 4, wherein a difference in refractive index between the first material layer (1161) having the relatively low refractive index and the second material layer (1162) having the relatively high refractive index ranges from 0.3 to 0.9.

6. The display device of any one of claims 2 to 5, wherein the second material layer (1162) having the relatively high refractive index has a refractive index higher than that of the first conductivity type semiconductor layer (1155).

7. The display device of any one of claims 1 to 6, wherein a corresponding semiconductor light emitting device has a size within a range from 10 micrometers to 100 micrometers in width and length, respectively.

8. The display device of any one of claims 1 to 7, wherein for each semiconductor light emitting device the first conductivity type electrode (1156) is connected to one of the first electrodes (1020) and the second conductivity type electrode (1152) is connected to one of the second electrodes (1040) with the first and second conductivity type semiconductor layers (1155, 1153) interposed therebetween.

9. The display device of claim 8, wherein at least a portion of the plurality of layers of the passivation layer (1160) covers side surfaces and a portion of a lower surface of the first conductivity type electrode (1156) .

10. The display device of claim 9, wherein the portion of the lower surface of the first conductivity type electrode (1156) which is covered by the passivation layer (1160) is an extending portion (1165) extending in a direction opposite to the protrusion portion (1164) from the other end of the body portion (1163).

## Patentansprüche

1. Anzeigevorrichtung umfassend:
ein Substrat (1010) mit einer Mehrzahl erster Elektroden (1020);
einer Mehrzahl von lichtemittierenden Halbleitervorrichtungen (1050), die auf dem Substrat (1010) angebracht und elektrisch mit den ersten Elektroden (1020) verbunden sind;
einer Mehrzahl zweiter Elektroden (1040), die die ersten Elektroden (1020) kreuzen und elektrisch mit den lichtemittierenden Halbleitervorrichtungen (1050) verbunden sind und zwischen den lichtemittierenden Halbleitervorrichtungen (1050) positioniert sind;
eine leitende Klebeschicht (1030), die zwischen dem Substrat (1010) und den zweiten Elektroden (1040) angeordnet ist und die lichtemittierenden Halbleitervorrichtungen (1050) elektrisch mit den ersten Elektroden (1020) verbindet, und
eine Leuchtstoffschicht (1080), die auf einer Oberfläche der Mehrzahl von lichtemittierenden Halbleitervorrichtungen (1050) gebildet ist;
wobei die lichtemittierenden Halbleitervorrichtungen (1050) umfassen:
eine Halbleiterschicht vom ersten Leitfähigkeitstyp (1155);
eine Elektrode vom ersten Leitfähigkeitstyp (1156), die auf der Halbleiterschicht vom ersten Leitfähigkeitstyp (1155) angeordnet ist;
eine Halbleiterschicht vom zweiten Leitfähigkeitstyp (1153), die die Halbleiterschicht vom ersten Leitfähigkeitstyp (1155) überlappt;
eine Elektrode vom zweiten Leitfähigkeitstyp (1152), die auf der Halbleiterschicht vom zweiten Leitfähigkeitstyp (1153) angeordnet ist; und
eine Passivierungsschicht (1160) mit einer Mehrzahl von Schichten (1161, 1162) mit unterschiedlichen Brechungsindizes,
**dadurch gekennzeichnet, dass** die Passivierungsschicht ferner umfasst:
einen Körperabschnitt (1163), der Seitenflächen der Halbleiterschichten vom ersten und zweiten Leitfähigkeitstyp (1153, 1155) bedeckt, um Licht zu reflektieren, das an Seitenflächen der lichtemittierenden Halbleitervorrichtung (1050) emittiert wird, und
einen Vorsprungsabschnitt (1164), der in einer Richtung hervorsteht, die den Körperabschnitt (1163) von einem Ende des Körperabschnitts (1163) kreuzt,
wobei der Vorsprungabschnitt (1164) eine Oberseite aufweist, die komplanar mit einer Oberseite der Halbleiterschicht vom zweiten Leitfähigkeitstyp (1153) ist,
der Vorsprungsabschnitt (1164) die Leuchtstoffschicht (1080) überlappt, die die lichtemittierenden Halbleitervorrichtungen (1050) bedeckt, und
der Vorsprungsabschnitt (1164) so eingerichtet ist, dass Licht, das von der Oberseite der Halbleiterschicht vom zweiten Leitfähigkeitstyp (1153) emittiert wird und in der Leuchtstoffschicht (1080) reflektiert wird, um sich in Richtung der leitenden Klebeschicht (1030) zu bewegen, durch den Vorsprungsabschnitt (1164) nach oben reflektiert wird.

2. Anzeigevorrichtung nach Anspruch 1, wobei die Mehrzahl von Schichten der Passivierungsschicht (1160) eine erste Materialschicht (1161) mit einem relativ niedrigen Brechungsindex und eine zweite Materialschicht (1162) mit einem relativ hohen Brechungsindex umfasst, die wiederholt aufeinandergestapelt sind.

3. Anzeigevorrichtung nach Anspruch 2, wobei die zweite Materialschicht (1162) mit dem relativ hohen Brechungsindex mindestens eines von SiN, TiO₂, Al₂O₃ und ZrO₂ enthält.

4. Anzeigevorrichtung nach einem der Ansprüche 2 bis 3, wobei die erste Materialschicht (1161) mit dem relativ niedrigen Brechungsindex in direktem Kontakt mit den Seitenflächen steht.

5. Anzeigevorrichtung nach einem der Ansprüche 2 bis 4, wobei ein Unterschied im Brechungsindex zwischen der ersten Materialschicht (1161) mit dem relativ niedrigen Brechungsindex und der zweiten Materialschicht (1162) mit dem relativ hohen Brechungsindex von 0,3 bis 0,9 reicht.

6. Anzeigevorrichtung nach einem der Ansprüche 2 bis 5, wobei die zweite Materialschicht (1162) mit dem relativ hohen Brechungsindex einen Brechungsindex aufweist, der höher als der der Halbleiterschicht vom ersten Leitfähigkeitstyp (1155) ist.

7. Anzeigevorrichtung nach einem der Ansprüche 1 bis 6, wobei eine entsprechende lichtemittierende Halbleitervorrichtung eine Größe in einem Bereich von 10 Mikrometern bis 100 Mikrometern in Breite bzw. Länge aufweist.

8. Anzeigevorrichtung nach einem der Ansprüche 1 bis 7, wobei für jede lichtemittierende Halbleitervorrichtung die Elektrode vom ersten Leitfähigkeitstyp (1156) mit einer der ersten Elektroden (1020) verbunden ist und die Elektrode vom zweiten Leitfähigkeitstyp (1152) mit einer der zweiten Elektroden (1040) verbunden ist, wobei die Halbleiterschichten vom ersten und zweiten Leitfähigkeitstyp (1155, 1153) dazwischen angeordnet sind.

9. Anzeigevorrichtung nach Anspruch 8, wobei zumindest ein Abschnitt der Mehrzahl von Schichten der Passivierungsschicht (1160) Seitenflächen und einen Abschnitt einer Unterseite der Elektrode vom ersten Leitfähigkeitstyp (1156) bedeckt.

10. Anzeigevorrichtung nach Anspruch 9, wobei der Abschnitt der Unterseite der Elektrode vom ersten Leitfähigkeitstyp (1156), der von der Passivierungsschicht (1160) bedeckt ist, ein Erstreckungsabschnitt (1165) ist, der sich in einer Richtung gegenüber dem Vorsprungsabschnitt (1164) vom anderen Ende des Körperabschnitts (1163) erstreckt.

## Revendications

1. Dispositif d'affichage, comprenant :
un substrat (1010) comprenant une pluralité de premières électrodes (1020);
une pluralité de dispositifs électroluminescents à semi-conducteurs (1050) montés sur le substrat (1010) et connectés électriquement aux premières électrodes (1020);
une pluralité de secondes électrodes (1040) coupant les premières électrodes (1020) et connectées électriquement aux dispositifs électroluminescents à semi-conducteurs (1050) et étant positionnées entre les dispositifs électroluminescents à semi-conducteurs (1050);
une couche adhésive conductrice (1030) disposée entre le substrat (1010) et les secondes électrodes (1040) et connectant électriquement les dispositifs électroluminescents à semi-conducteurs (1050) aux premières électrodes (1020), et
une couche de luminophore (1080) formée sur une surface de la pluralité de dispositifs électroluminescents à semi-conducteurs (1050);
dans lequel les dispositifs électroluminescents à semi-conducteurs (1050) comprennent:
une couche de semi-conducteur d'un premier type de conductivité (1155);
une électrode d'un premier type de conductivité (1156) disposée sur la couche de semi-conducteur d'un premier type de conductivité (1155);
une couche de semi-conducteur d'un second type de conductivité (1153) chevauchant la couche de semi-conducteur d'un premier type de conductivité (1155);
une électrode d'un second type de conductivité (1152) disposée sur la couche de semi-conducteur d'un second type de conductivité (1153); et
une couche de passivation (1160) comprenant une pluralité de couches (1161, 1162) ayant des indices de réfraction différents,
**caractérisé en ce que** la couche de passivation comprend en outre:
une partie corps (1163) recouvrant les surfaces latérales des couches de semi-conducteurs des premier et second type de conductivité (1153, 1155) pour réfléchir la lumière émise vers les surfaces latérales du dispositif électroluminescent à semi-conducteur (1050), et
une partie en saillie (1164) faisant saillie dans une direction coupant la partie corps (1163) à partir d'une extrémité de la partie corps (1163), dans laquelle
la partie en saillie (1164) a une surface supérieure coplanaire avec une surface supérieure de la couche de semi-conducteur du premier type de conductivité (1153),
la partie en saillie (1164) chevauche la couche de luminophore (1080) recouvrant les dispositifs électroluminescents à semi-conducteurs (1050), et
la partie en saillie (1164) étant configurée pour que la lumière émise depuis la surface supérieure de la couche de semi-conducteur du second type de conductivité (1153) et réfléchie à l'intérieur de la couche de luminophore (1080) de manière à se déplacer vers la couche adhésive conductrice (1030) soit réfléchie vers le haut par la partie en saillie (1164).

2. Dispositif d'affichage selon la revendication 1, dans lequel la pluralité de couches de la couche de passivation (1160) comprend une couche d'un premier matériau (1161) ayant un indice de réfraction relativement faible et une couche d'un second matériau (1162) ayant un indice de réfraction relativement élevé empilées de manière répétée les unes sur les autres.

3. Dispositif d'affichage selon la revendication 2, dans lequel la couche de second matériau (1162) ayant l'indice de réfraction relativement élevé comprend au moins l'un parmi le SiN, le TiO₂, l'Al₂O₃ et le ZrO₂.

4. Dispositif d'affichage selon l'une quelconque des revendications 2 à 3, dans lequel la couche de premier matériau (1161) ayant l'indice de réfraction relativement faible est en contact direct avec les surfaces latérales.

5. Dispositif d'affichage selon l'une quelconque des revendications 2 à 4, dans lequel une différence d'indice de réfraction entre la couche de premier matériau (1161) ayant l'indice de réfraction relativement faible et la couche de second matériau (1162) ayant l'indice de réfraction relativement élevé va de 0,3 à 0,9.

6. Dispositif d'affichage selon l'une quelconque des revendications 2 à 5, dans lequel la couche de second matériau (1162) ayant l'indice de réfraction relativement élevé a un indice de réfraction supérieur à celui de la couche de semi-conducteur du premier type de conductivité (1155).

7. Dispositif d'affichage selon l'une quelconque des revendications 1 à 6, dans lequel un dispositif électroluminescent à semi-conducteur correspondant a une taille dans une plage de 10 micromètres à 100 micromètres en largeur et en longueur, respectivement.

8. Dispositif d'affichage selon l'une quelconque des revendications 1 à 7, dans lequel pour chaque dispositif électroluminescent à semi-conducteur, l'électrode du premier type de conductivité (1156) est connectée à l'une des premières électrodes (1020) et l'électrode du second type de conductivité (1152) est connectée à l'une des secondes électrodes (1040) avec les couches de semi-conducteurs des premier et second types de conductivité (1155, 1153) interposées entre elles.

9. Dispositif d'affichage selon la revendication 8, dans lequel au moins une partie de la pluralité de couches de la couche de passivation (1160) recouvre des surfaces latérales et une partie d'une surface inférieure de l'électrode du premier type de conductivité (1156).

10. Dispositif d'affichage selon la revendication 9, dans lequel la partie de la surface inférieure de l'électrode du premier type de conductivité (1156) qui est recouverte par la couche de passivation (1160) est une partie d'extension (1165) s'étendant dans une direction opposée à la partie en saillie (1164) depuis l'autre extrémité de la partie corps (1163).
